(19) Europäisches Patentamt
European Patent Office
Office européen des brevets

(11) **EP 3 803 355 B1**

(12) **EUROPEAN PATENT SPECIFICATION**

(45) Date of publication and mention
of the grant of the patent:
**06.09.2023 Bulletin 2023/36**

(21) Application number: **19812259.0**

(22) Date of filing: **30.05.2019**

(51) International Patent Classification (IPC):
**G01N 22/00** (2006.01)    **H05K 13/08** (2006.01)
**H05K 3/12** (2006.01)    **G01N 21/3581** (2014.01)
**H05K 1/02** (2006.01)    **H05K 1/09** (2006.01)
**G01N 21/956** (2006.01)    **G01R 31/308** (2006.01)
**G01N 22/02** (2006.01)

(52) Cooperative Patent Classification (CPC):
**G01N 22/02; G01N 21/3581; G01N 21/956;**
**G01R 31/308; H05K 1/0268; H05K 3/125;**
**H05K 13/082;** H05K 1/097; H05K 2201/10098;
H05K 2203/1131; H05K 2203/1545

(86) International application number:
**PCT/CA2019/050743**

(87) International publication number:
**WO 2019/227220 (05.12.2019 Gazette 2019/49)**

(54) **ELECTRONIC DEVICE TESTING SYSTEM, ELECTRONIC DEVICE PRODUCTION SYSTEM INCLUDING SAME AND METHOD OF TESTING AN ELECTRONIC DEVICE**

PRÜFSYSTEM FÜR EINE ELEKTRONISCHE VORRICHTUNG, DIESES ENTHALTENDE SYSTEM ZUR HERSTELLUNG ELEKTRONISCHER VORRICHTUNGEN UND VERFAHREN ZUM TESTEN EINER ELEKTRONISCHEN VORRICHTUNG

SYSTÈME DE TEST DE DISPOSITIF ÉLECTRONIQUE, SYSTÈME DE PRODUCTION DE DISPOSITIF ÉLECTRONIQUE LE COMPRENANT ET PROCÉDÉ DE TEST D'UN DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2018 US 201862678479 P**

(43) Date of publication of application:
**14.04.2021 Bulletin 2021/15**

(73) Proprietor: **Socovar SEC**
**Montréal, Québec H3C 2G9 (CA)**

(72) Inventors:
• **BLANCHARD, François**
**Montréal, Québec H2G 2S1 (CA)**
• **ZHULDYBINA, Mariia**
**Montréal, Québec H3C 0J9 (CA)**

(74) Representative: **Cabinet Novitech**
**188 Grande rue Charles de Gaulle**
**94130 Nogent-sur-Marne (FR)**

(56) References cited:
**WO-A2-2012/094436**    **US-A- 4 401 686**
**US-B2- 9 030 286**

• ZENG YANG ET AL: "Terahertz characterisation of UV offset lithographically printed electronic-ink", ORGANIC ELECTRONICS, vol. 48, 10 June 2017 (2017-06-10), pages 382-388, XP085129539, ISSN: 1566-1199, DOI: 10.1016/J.ORGEL.2017.06.012
• WITHAYACHUMNANKUL W ET AL: "Metamaterials in the Terahertz Regime", IEEE PHOTONICS JOURNAL, IEEE, USA, vol. 1, no. 2, 1 August 2009 (2009-08-01), pages 99-118, XP011269937, ISSN: 1943-0655, DOI: 10.1109/JPHOT.2009.2026288

• **WITHAYACHUMNANKUL et al.: "Metamaterials in the Terahertz Regime", IEEE, vol. 1, no. 2, August 2009 (2009-08), pages 99-118, XP011484891, DOI: 10.1109/JPHOT.2009.2026288**

## Description

### FIELD

The improvements generally relate to the field of printed electronic devices and more specifically relate to control such printed electronic devices.

### BACKGROUND

Printed electronic devices are typically made from substrates on which electronic circuits are printed. As can be understood, printing of an electronic device generally involves depositing conductive ink on a substrate in a predetermined pattern to form conductive traces. The printing of such electronic circuits can be performed using conventional printing techniques suitable for defining patterns on substrates, such as screen printing, flexography, gravure, offset lithography, inkjet, sintering and the like. Printed electronic techniques enable for low-cost fabrication and large-volume production of electronic devices for applications such as flexible displays to name only one example.

As with any other production process, testing of some or all of the electronic devices during the production process is key in achieving a satisfactory production process. For instance, if the conductivity of the ink used in the printing technique varies below a given conductivity threshold over time, the operability of the resulting printed electronic devices could be negatively affected. As such, one technique to test the conductivity of the ink of a printed electronic device involves contacting measurement probes on the conductive traces to make a direct conductivity measurement at some point in the production process. However, such a testing technique can provide conductivity measurements which are limited in resolution. Moreover, this testing technique requires a physical contact of the traces, which can cause irreparable damage to the printed electronic device in at least some situations. The document "Terahertz characterisation of UV offset lithographically printed electronic-ink", Zeng Yang et al, Organic Electronics, Vol. 48, 10 June 2017, P. 382-388 discloses the testing of printed electronic circuits with waves in the range of THz frequencies.

Although existing testing techniques are satisfactory to a certain degree, there remains room for improvement, especially in providing printed electronic device testing systems and methods which alleviate at least some of the above-mentioned drawbacks.

### SUMMARY

According to the invention, there is provided an electronic device testing system for testing an electronic device having a substrate on which a metamaterial structure is printed using an ink, the electronic device testing system comprising: a terahertz radiation emitter configured to emit an incident terahertz radiation beam to be incident on the metamaterial structure of the substrate, the incident terahertz radiation beam having power at least at the terahertz resonance frequency of the metamaterial structure; a terahertz radiation receiver configured to receive an outgoing terahertz radiation beam outgoing from the metamaterial structure and to measure an amplitude of an electric field of the outgoing terahertz radiation beam at least at the terahertz resonance frequency; and a controller configured to determine a conductivity value indicative of a conductivity of the ink based on said amplitude of the electric field of the outgoing terahertz radiation The controller is also configured to generate a signal indicative of an action to be performed when the determined conductivity of the ink is below a given conductivity threshold.

The terahertz radiation emitter is for example a broadband terahertz radiation emitter, the terahertz radiation receiver being configured to measure a spectral power distribution of the outgoing terahertz radiation beam, the system further comprising a broadband terahertz radiation reference receiver configured to measure a spectral power distribution of a portion of the incident terahertz radiation beam, the controller being configured to determine the conductivity value based on the spectral power distribution of the incident terahertz radiation beam and on the spectral power distribution of the outgoing terahertz radiation beam.

The terahertz radiation emitter is for example a broadband terahertz radiation emitter, the terahertz radiation receiver being configured to measure a spectral power distribution of the outgoing terahertz radiation beam, the controller being configured to determine the conductivity value based on an amplitude of a first spectral region including the terahertz resonance frequency and on an amplitude of a second spectral region being spectrally spaced-apart from the first spectral region.

The metamaterial structure is for example provided in the form of a vortex phase plate.

The terahertz radiation receiver is for example a terahertz radiation image receiver, the controller being configured to determine the conductivity value based on an amplitude of the electric field of the outgoing terahertz radiation beam at a central region thereof.

The terahertz radiation emitter and the terahertz radiation receiver are for example complementary metal-oxide-semiconductor devices, the electronic device testing system being portable.

Said action includes for example generating a file indicating that the electronic device has been printed with ink having a conductivity value being below the given conductivity threshold.

Said action includes for example modifying at least one printing parameter of said electronic device printing system.

Said action includes for example one of partially and wholly reprinting the electronic circuit of the electronic device after said modifying.

According to another aspect of the invention, there is provided a method for testing an electronic device having an electronic circuit being printed on a given area of a substrate using an ink and a metamaterial structure being printed on a remaining area of the substrate, the metamaterial structure comprising a pattern of elements providing a terahertz resonance frequency to the metamaterial structure using the ink, the method comprising: emitting a terahertz radiation emitter incident on the metamaterial structure of the substrate, the incident terahertz radiation beam having power at least at the terahertz resonance frequency of the metamaterial structure, thereby causing an outgoing terahertz radiation beam to be outgoing from the metamaterial structure; the metamaterial structure modifying a first spectral power distribution of the incident terahertz beam and thereby causing an outgoing terahertz radiation beam to have a second spectral power distribution being different from the first spectral power distribution; measuring an amplitude of an electric field of the outgoing terahertz radiation beam at least at the terahertz resonance frequency; and using a controller being communicatively coupled to at least the terahertz radiation receiver, determining a conductivity value indicative of a conductivity of the ink based on said amplitude.

The incident terahertz radiation beam for example is a broadband terahertz radiation beam, said measuring including measuring a spectral power distribution of the outgoing terahertz radiation beam, the method further comprising measuring a spectral power distribution of a portion of the incident terahertz radiation beam, said determining including determining the conductivity value based on the spectral power distribution of the incident terahertz radiation beam and on the spectral power distribution of the outgoing terahertz radiation beam.

The terahertz radiation beam for example is a broadband terahertz radiation beam, said measuring including measuring a spectral power distribution of the outgoing terahertz radiation beam, said determining comprising determining the conductivity value based on an amplitude of a first spectral region including the terahertz resonance frequency and on an amplitude of a second spectral region being spectrally spaced-apart from the first spectral region.

The metamaterial structure is for example provided in the form of a vortex phase plate, said measuring including measuring an image of the outgoing terahertz radiation beam, said determining comprising determining the conductivity value based on an amplitude of the electric field of the outgoing terahertz radiation beam at a central region thereof.

Upon determining that the conductivity value is lower than a conductivity value threshold, generating for example a signal indicative of an action to be performed.

Said action including for example generating a file indicating that the electronic device has been printed with unsatisfactory ink.

Upon determining that the conductivity value is lower than a conductivity value threshold, updating for example current printing parameters to updated printing parameters based on said determined conductivity value.

Reprinting for example the electronic circuit on the given area of the substrate based on said updated printing parameters. In some embodiments, the updated printing parameters are used to print subsequent electronic devices only. The electronic device printed with unsatisfactory ink need not be reprinted, as it may be discarded in at least some situations.

Printing for example the metamaterial structure on the remaining area of the substrate using the ink.

It will be understood that the expression "computer" as used herein is not to be interpreted in a limiting manner. It is rather used in a broad sense to generally refer to the combination of some form of one or more processing units and some form of memory system accessible by the processing unit(s). Similarly, the expression "controller" as used herein is not to be interpreted in a limiting manner but rather in a general sense of a device, or of a system having more than one device, performing the function(s) of controlling one or more devices such as an electronic device, for instance.

It will be understood that the various functions of a computer or of a controller can be performed by hardware or by a combination of both hardware and software. For example, hardware can include logic gates included as part of a silicon chip of the processor. Software can be in the form of data such as computer-readable instructions stored in the memory system. With respect to a computer, a controller, a processing unit, or a processor chip, the expression "configured to" relates to the presence of hardware or a combination of hardware and software which is operable to perform the associated functions.

The term "amplitude" is used broadly herein so as to encompass terms such as "intensity," "irradiance" and the like.

## DESCRIPTION OF THE FIGURES

In the figures,

Fig. 1 is a schematic view of an example of an electronic device production system including an electronic device printing system, an electronic device testing system and a controller, in accordance with one or more embodiments;

Fig. 2 is a top view of an example of an electronic device including a substrate on which an electronic circuit is printed and a metamaterial structure using the electronic device printing system of Fig. 1, in accordance with one or more embodiments;

Figs. 3A and 3B are top views of examples of metamaterial structures of the electronic device of Fig. 2, in accordance with some embodiments;

Fig. 4 is a flowchart of a method for testing the electronic device of Fig. 2, in accordance with one or more embodiments;

Fig. 5 is a schematic view of an exemplary computing device of the controller of Fig. 1, in accordance with one or more embodiments;

Fig. 6 is a schematic view of an example of a software application of the controller of Fig. 1 being configured to perform at least some steps of the method of Fig. 4, in accordance with one or more embodiments;

Fig. 7 is a schematic view of an example of an electronic device testing system, with broadband terahertz radiation reference and measurement receivers, in accordance with one or more embodiments;

Fig. 8A is a graph showing reference and measurement electric field amplitudes as measured using the broadband terahertz radiation reference and measurement receivers of Fig. 7, respectively, in accordance with one or more embodiments;

Fig. 8B is a graph showing the measurement electric field amplitude of Fig. 8A normalized using the reference electric field amplitude of Fig. 8A, in accordance with one or more embodiments;

Fig. 9 is a schematic view of another example of an electronic device testing system, with a single broadband terahertz radiation receiver, in accordance with one or more embodiments;

Fig. 10 is a graph showing the electric field amplitude as measured by the broadband terahertz radiation receiver of Fig. 9;

Fig. 11 is a schematic view of another example of an electronic device testing system, with a metamaterial structure provided in the form of a vortex phase plate, and a monochromatic broadband terahertz radiation image receiver, in accordance with one or more embodiments;

Fig. 12 is an oblique view of the vortex phase plate of Fig. 11, showing incident and outgoing terahertz radiation beams, in accordance with one or more embodiments;

Fig. 13A is a graph showing spatial distributions of the incident and outgoing terahertz radiation beams of Fig. 12, in accordance with one or more embodiments;

Fig. 13B is an example of an image produced by the monochromatic broadband terahertz radiation image receiver of Fig. 11 when the ink used to print the vortex phase plate of Fig. 12 is not satisfactorily conductive and/or or non-conductive, in accordance with one or more embodiments;

Fig. 13C is an example of an image produced by the monochromatic broadband terahertz radiation image receiver of Fig. 11 when the ink used to print the vortex phase plate of Fig. 12 is satisfactorily conductive, in accordance with one or more embodiments;

Fig. 14A is a top view of an example of the vortex phase plate of Fig. 12, showing a plurality of subsets of elbow-shaped elements, in accordance with one or more embodiments;

Figs. 14B and 14C are top views of examples of the elbow-shaped elements of Fig. 14A, in accordance with one or more embodiments;

Figs. 15A-D are top views of examples of vortex phase plates, in accordance with some embodiments;

Fig. 16 is a schematic view of an example of the electronic device testing system of Fig. 11, shown in a portable format, in accordance with one or more embodiments;

Fig. 17 is an oblique view of an example setup to compare the conductivity measurements using of an example of the THz-TDS of Fig. 16 and other measurement setups including an atomic force microscopy (AFM) measurement setup, a four-point probe (4PP) measurement setup, and a multimeter measurement setup, in accordance with one or more embodiments;

Fig. 18A is a graph showing time-domain spectra of the vortex phase plate of Fig. 17 and its reference obtained using the THz-TDS of Fig. 16;

Fig. 18B is a graph showing transmitted amplitude THz spectra of the vortex phase plate of Fig. 17, showing spectral regions probed by a dual-wavelength THz spectroscopy (DWTS) receiver, in accordance with one or more embodiments;

Fig. 19A is a graph showing normalized transmission spectra of the experimental results obtained with the THz-TDS of Fig. 16 for vortex phase plates having different conductivity values, in accordance with one or more embodiments;

Fig. 19B is a graph showing simulated normalized transmission spectra with finite difference time domain (FDTD) method, in accordance with one or more embodiments;

Fig. 19C is a graph showing conductivity values over time, the values being obtained using a two microprobes (2MP) measurement setup, the 4PP measurement setup, the THz-TDS of Fig. 16 and the DWTS receiver;

Fig. 19D is a graph showing simulated transmission amplitude at 0.26 THz as a function of conductivity, in accordance with one or more embodiments; and

Fig. 20 is a table comparing conductivity measurements performed using the THz-TDS of Fig. 16 and other conventional techniques.

## DETAILED DESCRIPTION

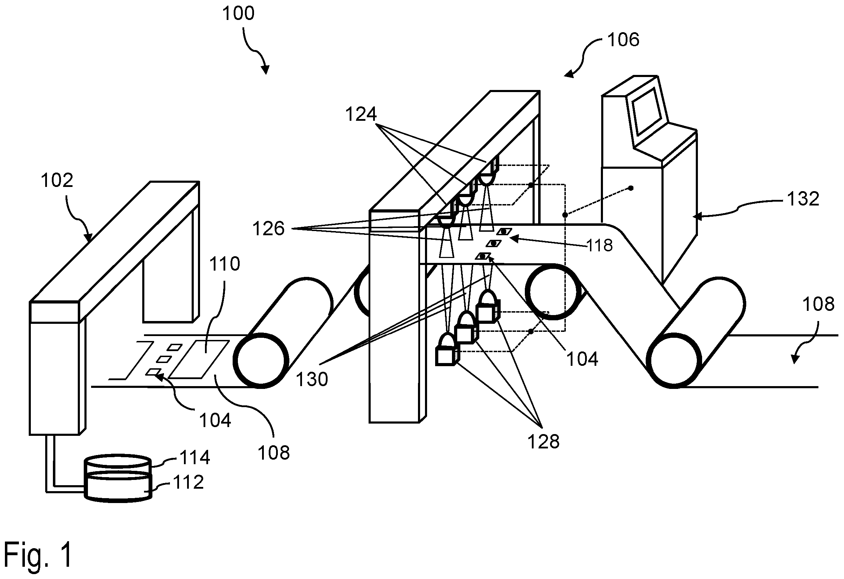

Fig. 1 shows an example of an electronic device production system 100, in accordance with one or more embodiments. As depicted in this specific example, the electronic device production system 100 has an electronic device printing system 102 for printing electronic devices 104. An electronic device testing system 106 is also provided for testing the previously printed electronic devices 104.

In this example, the electronic device printing system 102 is configured to receive a substrate 108 and to print an electronic circuit 110 thereon using conductive ink according to conventional printing techniques. For instance, in this specific embodiment, the electronic device printing system 102 is configured to draw ink 112 from an ink reservoir 114 and to deposit the ink 112 in predetermined patterns on the substrate 108 to form the electronic circuit 110.

In this specific embodiment, the ink 112 includes silver nanoparticles which can be sintered to one another to form the electronic circuit 110. However, in some other examples, the ink 122 can include gold nanoparticles, copper nanoparticles, and the like. Any type of commercially available or otherwise conventional conductive ink can be used.

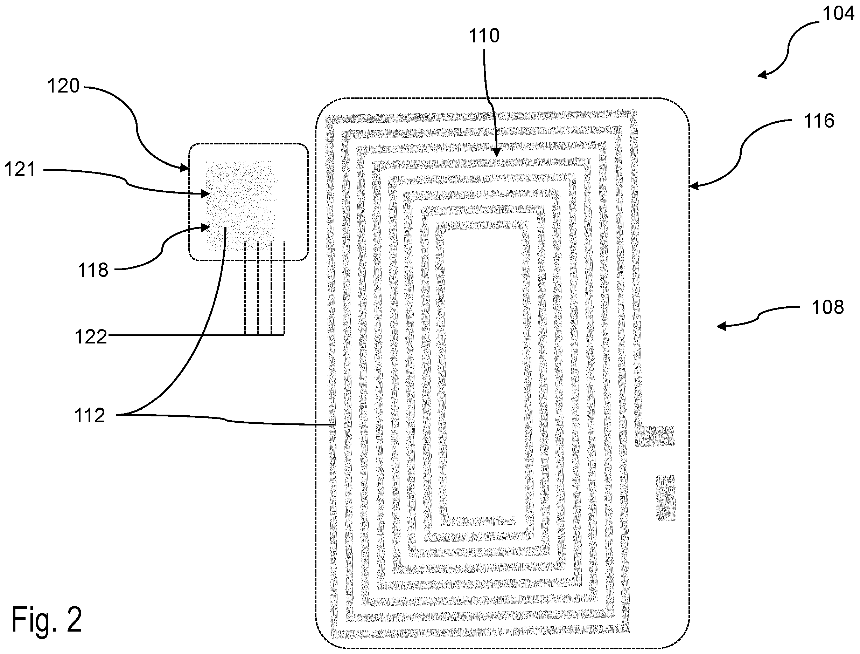

Referring now to Fig. 2, the electronic device printing system 102 is configured to print the electronic circuit 110 on a given area 116 of the substrate 108 using the ink 112 and to also print a metamaterial structure 118 on a remaining area 120 of the substrate 108 using the same ink 112.

The metamaterial structure 118 is configured to interact at terahertz frequencies, usually defined as 0.1 to 10 THz, preferably between 100 GHz and 1 THz, and most preferably of about 230 GHz. Indeed, terahertz radiation lies at the far end of the infrared band, just after the end of the microwave band, and corresponds to millimeter and submillimeter wavelengths between 3 mm and 0.03 mm. The term "terahertz" is meant to be interpreted broadly so as to encompass frequencies lying near the commonly accepted boundaries of the terahertz region of the electromagnetic spectrum.

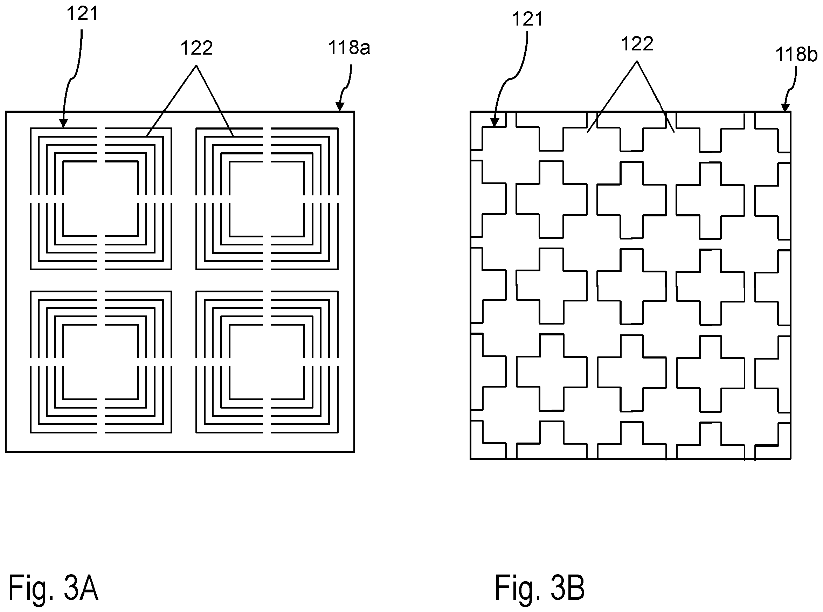

More specifically, the metamaterial structure 118 shown in this example has a pattern 121 of elements 122 which collectively provide a terahertz resonance frequency to the metamaterial structure 118. Figs. 3A and 3B show other examples of metamaterial structures 118a and 118b in greater detail. As can be understood, any suitable metamaterial structure providing a terahertz resonance frequency can be used.

In these examples, the metamaterial structures 118a and 118b can have dimensions ranging between 1 mm and 50 mm, preferably between 5 mm and 30 mm, and most preferably between 10 mm and 25 mm. The elements 122 can have dimensions ranging between 0.02 mm and 1.00 mm, preferably between 0.1 and 0.8 mm, and most preferably between 0.5 and 0.7 mm.

Referring back to Fig. 1, the electronic device testing system 106 has one or more terahertz radiation emitters (hereinafter "the terahertz radiation emitters 124") which are each configured to emit an incident terahertz radiation beam 126 to be incident on the metamaterial structure 118 of the substrate 108 of the electronic device 104.

It is intended that the incident terahertz radiation beam 126 has power at least at least the terahertz resonance frequency of the metamaterial structure 118 so that a spectral power distribution of the incident terahertz radiation beam 126 can be modified depending on an actual conductivity of the ink 112 used to print the metamaterial structure 118.

Generally, the greater the conductivity value of the ink 112 is, the more the metamaterial structure 118 will absorb, scatter and/or diffract power at the terahertz resonance frequency. Conversely, the lower the conductivity value of the ink 112 is, the lesser the metamaterial structure 118 will absorb and/or diffract power at the terahertz resonance frequency.

The electronic device testing system 106 has one or more terahertz radiation receivers (hereinafter "the terahertz radiation receivers 128") which are each configured to receive an outgoing terahertz radiation beam 130 outgoing from the metamaterial structure 118 and to measure an amplitude of an electric field (sometimes referred to simply as "electric field amplitude") of the outgoing terahertz radiation beam 130 at least at the terahertz resonance frequency.

In some embodiments, the terahertz radiation receiver 128 is a terahertz time domain spectroscopy (THz-TSD) receiver which measures an amplitude of the electric field of the outgoing terahertz radiation beam 130 as function of time, and which is configured for performing a Fourier transform of that signal to provide amplitude as a function of frequency. However, the terahertz radiation receiver 128 can be any type of suitable terahertz radiation receiver such as a terahertz spectrometer or imager, for instance.

As illustrated, the substrate 108 in this example is disposed between the terahertz radiation emitters 124 and the terahertz radiation receivers 128. As such, the outgoing terahertz radiation beam 130 results from the propagation of the incident terahertz radiation beam 126 through the substrate 108 and is thus collinear with the incident terahertz radiation beam 126 in this example.

However, in some other embodiments, the terahertz radiation emitters 124 and the terahertz radiation receivers 128 can be disposed on a same side relative to the substrate 108, in which case the outgoing terahertz radiation beam 130 can result from reflection, scattering and/or diffraction of the incident terahertz radiation beam 130 on the substrate 108. In other words, in some embodiments, the outgoing terahertz radiation beam 130 can include the remaining part of the incident terahertz radiation beam that is not absorbed by the metamaterial structure 118. In some embodiments, the terahertz radiation beam can include terahertz radiation of the incident terahertz radiation beam that is scattered and/or otherwise diffracted by the metamaterial structure 118.

As depicted in this example, the electronic device testing system 106 has a controller 132 which is communicatively coupled to the electronic device printing system 102, to the terahertz radiation emitters 124 and to the terahertz radiation receivers 128.

The controller 132 is configured to determine a conductivity value being indicative of a conductivity of the ink 112 based on the amplitude of the electric field of the outgoing terahertz beam 130 at least at the terahertz resonance frequency.

In this example, the controller 132 is configured to generate a signal indicative of an action to be performed when the determined conductivity of the ink 112 is below a given conductivity threshold.

For instance, in some embodiments, the controller 132 is configured to generate an electronic file or alert indicating that one or more of the electronic devices 104 have been printed with ink having a conductivity value which is below the given conductivity threshold. Accordingly, the electronic devices logged in this file or alert can be later removed from the production line as they are most likely to be unsatisfactory.

In some other embodiments, the controller 132 is configured to modify at least one printing parameter of the electronic device printing system 102. For instance, the printing parameter can include, but is not limited to, a flow rate indicative at which flow rate the ink 112 is deposited on the substrate 108, a thickness of the conductive traces that are printed, a percentage of conductive material (e.g., silver nanoparticles) in the ink 112, a temperature of the sintering system, and other suitable printing parameters which can lead to increasing the conductivity of the ink 112 drawn from the ink reservoir 114.

In these embodiments, once one or more printing parameters have been modified, for electronic devices having been identified as unsatisfactory, the controller 132 can instruct the electronic device printing system 102 to reprint, wholly or partially, the electronic circuit of these electronic circuits so as to render them satisfactory. As can be understood, proceeding accordingly can reduce losses, and thus increase efficiency of the production line.

As can be understood, the electronic device testing system 106 can allow the quality of the printed electronic devices 104 to be controlled and optimized in real time or quasi real time based on the determined conductivity value during production of the electronic devices.

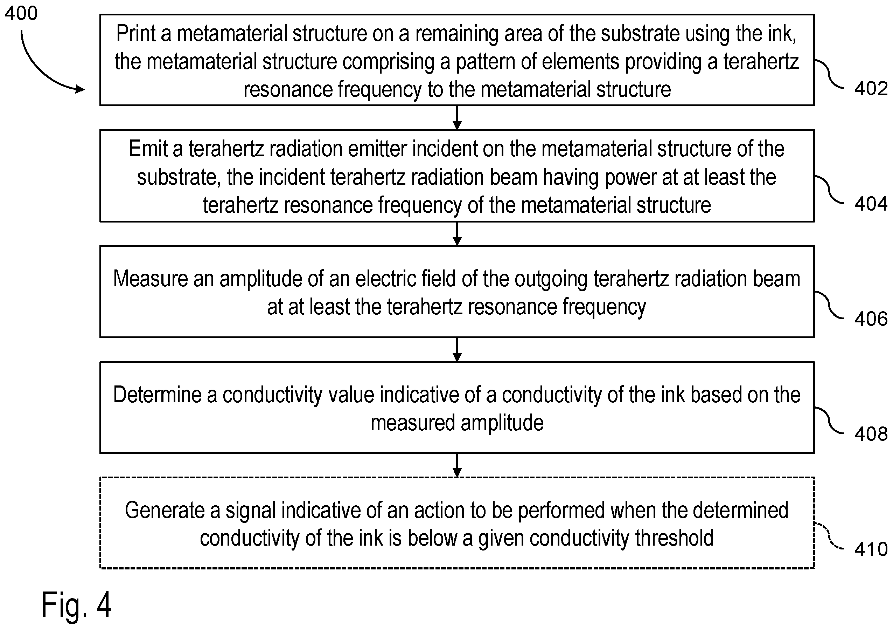

Fig. 4 shows a flowchart of an example of a method 400 for testing an electronic device 104 having the electronic circuit 110 being printed on the given area 116 of the substrate 108 using the ink 112. The method 400 will be described with reference to the electronic device production system 100 of Fig. 1 for ease of reading.

At step 402, the electronic device printing system 102 prints a metamaterial structure 118 on a remaining area 120 of the substrate 108 using the ink 112. As mentioned above, the metamaterial structure 118 has a pattern 121 of elements 122 providing a terahertz resonance frequency to the metamaterial structure 118. Accordingly, should the ink 112 be conductive to a satisfactory extent, the metamaterial structure 118 would absorb power of an incident terahertz radiation beam at least at the terahertz resonance frequency.

At step 404, each terahertz radiation emitter 124 emits a terahertz radiation beam 126 so as to be incident on the metamaterial structure 118 printed on the substrate 108. As discussed, the incident terahertz radiation beam 126 has power at least at the terahertz resonance frequency of the metamaterial structure 118, leaving an outgoing terahertz radiation beam 130 to be outgoing from the metamaterial structure 118.

At this stage of the method, the metamaterial structure 118 modifies a first spectral power distribution of the incident terahertz beam 126 which thereby causes the outgoing terahertz radiation beam 130 to have a second spectral power distribution being different from the first spectral power distribution should the ink 112 of the metamaterial structure 118 be conductive to a certain extent.

At step 406, each terahertz radiation receiver 128 measures an amplitude of an electric field of the outgoing terahertz radiation beam 130 at least at the terahertz resonance frequency.

At step 408, the controller 132 determines a conductivity value indicative of a conductivity of the ink 112 based on the measured amplitude of the electric field of the outgoing terahertz radiation beam 130.

At step 410, the controller 132 generates one or more signals indicative of one or more actions to be performed when the determined conductivity of the ink 112 of the metamaterial structure 118 is determined to be below a given conductivity threshold. Step 410 may be omitted in some embodiments.

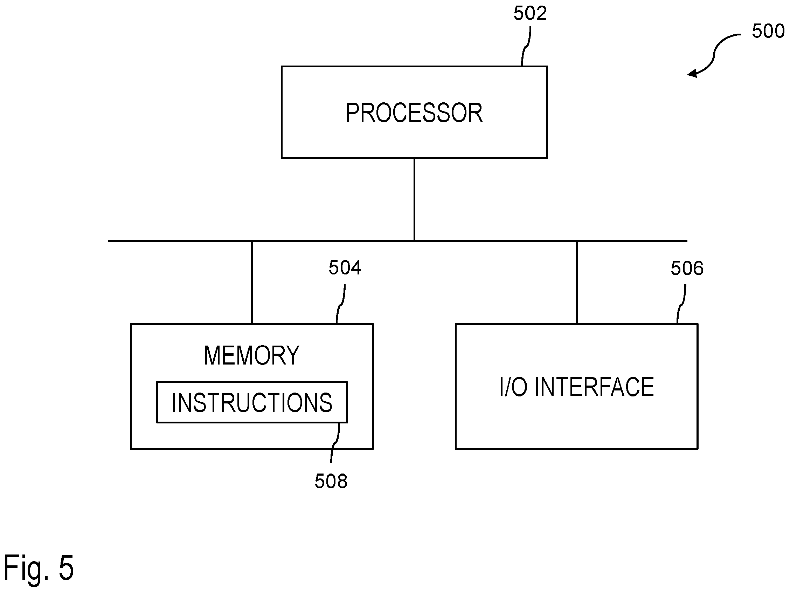

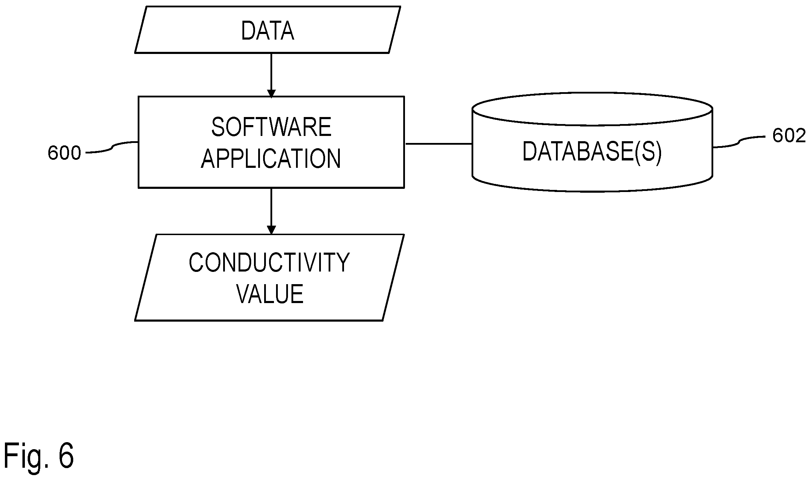

The controller 132 can be provided as a combination of hardware and software components. The hardware components can be implemented in the form of a computing device 500, an example of which is described with reference to Fig. 5. Moreover, the software components of the controller 132 can be implemented in the form of a software application 600, an example of which is described with reference to Fig. 6.

Referring to Fig. 5, the computing device 500 can have a processor 502, a memory 504, and I/O interface 506. Instructions 508 for performing the method 400, and/or any other related steps described herein, can be stored on the memory 504 and are accessible by the processor 502.

The processor 502 can be, for example, a general-purpose microprocessor or microcontroller, a digital signal processing (DSP) processor, an integrated circuit, a field programmable gate array (FPGA), a reconfigurable processor, a programmable read-only memory (PROM), or any combination thereof.

The memory 504 can include a suitable combination of any type of computer-readable memory that is located either internally or externally such as, for example, random-access memory (RAM), read-only memory (ROM), compact disc read-only memory (CDROM), electro-optical memory, magneto-optical memory, erasable programmable read-only memory (EPROM), and electrically-erasable programmable read-only memory (EEPROM), Ferroelectric RAM (FRAM) or the like.

Each I/O interface 506 enables the computing device 500 to interconnect with one or more input devices, such as the terahertz radiation receivers 128, or with one or more output devices such as the electronic device printing system 102, the terahertz radiation emitters 124, the sintering system and any other component of the production line if need be.

Each I/O interface 506 enables the controller 132 to communicate with other components, to exchange data with other components, to access and connect to network resources, to serve applications, and perform other computing applications by connecting to a network (or multiple networks) capable of carrying data including the Internet, Ethernet, plain old telephone service (POTS) line, public switch telephone network (PSTN), integrated services digital network (ISDN), digital subscriber line (DSL), coaxial cable, fiber optics, satellite, mobile, wireless (e.g. Wi-Fi, WiMAX), SS7 signaling network, fixed line, local area network, wide area network, and others, including any combination of these.

Referring now to Fig. 6, the software application 600 is configured to receive one or more amplitude signal, values and/or data and to determine a conductivity value upon processing the amplitude values. In some embodiments, the software application 600 is stored on the memory 504 and accessible by the processor 502 of the computing device 500.

In some embodiments, one or more conductivity threshold values $P_{th}$ can be stored in one or more databases 602 which are accessible by the software application 600. In some other embodiments, the action(s) and/or instruction(s) to be performed when the determined conductivity value is above one of the conductivity threshold values $P_{th}$ can also be stored on the databases 602.

The computing device 500 and the software application 600 described above are meant to be examples only.

Other suitable embodiments of the controller 132 can also be provided, as it will be apparent to the skilled reader.

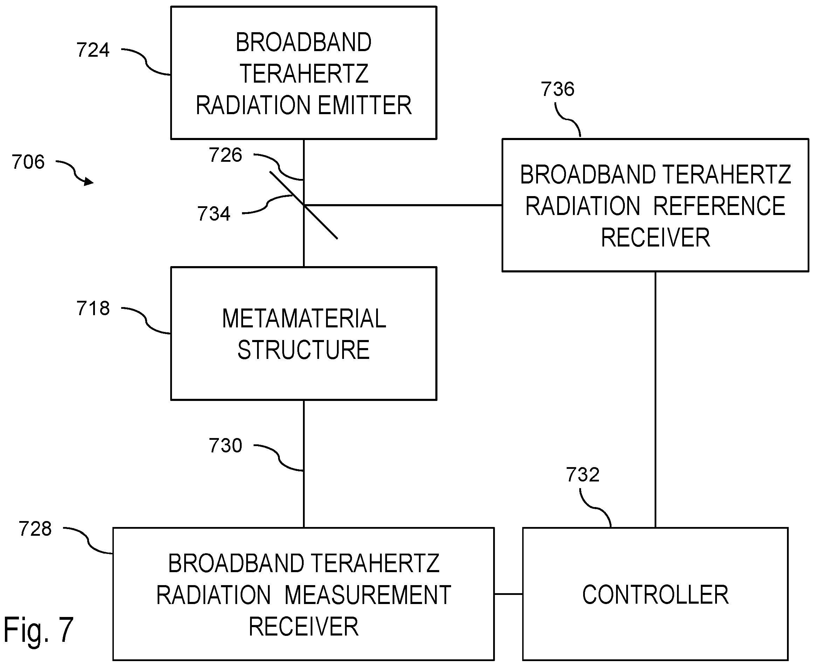

Fig. 7 shows another example of an electronic device testing system 706, in accordance with another embodiment. As depicted, the electronic device testing system 706 has a broadband terahertz radiation emitter 724 which is configured to emit a broadband terahertz radiation beam 726 towards the metamaterial structure 718.

As can be understood, the terahertz radiation beam 726 is broadband as it has power at the terahertz resonance frequency of the metamaterial structure but also at other surrounding frequencies, spectrally-spaced from the terahertz resonance frequency. In other words, the broadband terahertz radiation beam 726 has power within a given range of frequencies including, the terahertz resonance frequency among other frequencies.

The electronic device testing system 706 has a terahertz radiation beam splitter 734 which is configured to redirect a portion of the incident terahertz radiation beam 726 towards a broadband terahertz radiation reference receiver 736 where a reference values can be measured.

The electronic device testing system 706 also has a broadband terahertz radiation measurement receiver 728 which is configured to receive a terahertz radiation beam 730 outgoing from the metamaterial structure 718.

In this example, the controller 732 receives data indicative of a spectral power distribution of the incident terahertz radiation beam 726 measured by the broadband terahertz radiation reference receiver 736 and a spectral power distribution of the outgoing terahertz radiation beam 730 as measured by the broadband terahertz radiation measurement receiver 728.

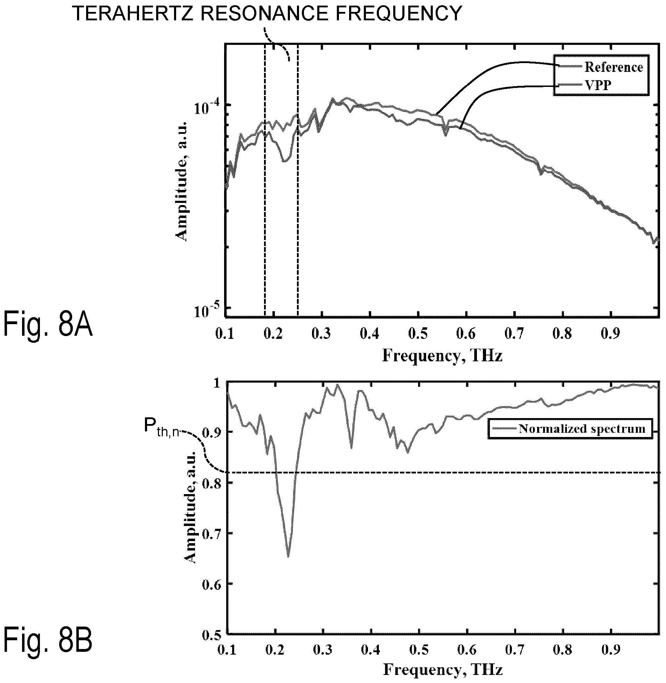

Examples of such data are shown in Fig. 8A. As can be seen, in this example, the ink of the metamaterial structure 718 has a certain conductivity, as there is a difference in the amplitudes of the electric fields of the incident and outgoing terahertz radiation beams 726 and 730. This is emphasized in Fig. 8B, where a normalized spectral power distribution is shown. The normalized spectral power distribution can be obtained by dividing the spectral power distribution measured using the broadband terahertz radiation measurement receiver 728 by the spectral power distribution measured using the broadband terahertz radiation reference receiver 736. In this example, the conductivity value threshold $P_{th}$ can be provided in the form of a normalized spectral power threshold $P_{th,n}$ below which the conductivity value can be deemed to be satisfactory.

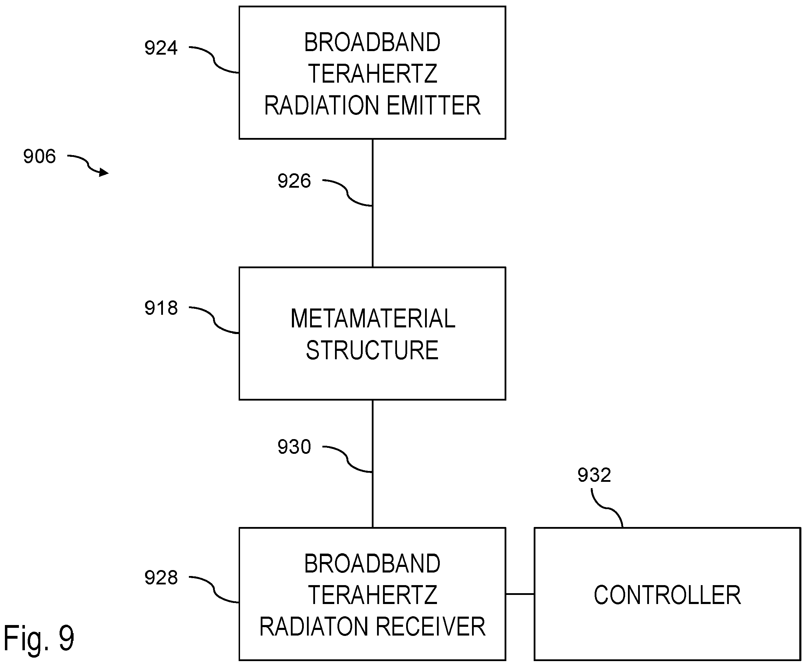

Fig. 9 shows another example of an electronic device testing system 906, in accordance with another embodiment. As depicted, the electronic device testing system 906 has a single broadband terahertz radiation emitter 924 which is configured to emit a broadband terahertz radiation beam 926 towards the metamaterial structure 918.

Similarly, the terahertz radiation beam 926 is broadband as it has power at the terahertz resonance frequency of the metamaterial structure and also at other frequencies, spectrally-spaced from the terahertz resonance frequency.

In this example, the electronic device testing system 906 also has a single broadband terahertz radiation receiver 928 which is configured to receive a terahertz radiation beam 930 outgoing from the metamaterial structure 918.

In this example, the controller 932 receives data indicative of a spectral power distribution of the outgoing terahertz radiation beam 930 as measured by the broadband terahertz radiation receiver 928.

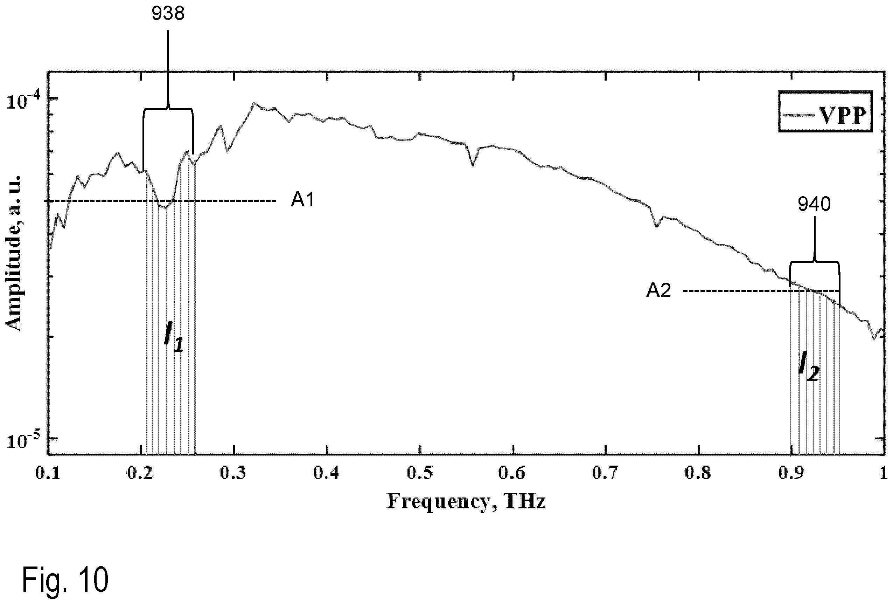

Examples of such data are shown in Fig. 10. As can be seen, in this example, the ink of the metamaterial structure 918 has a certain conductivity, as there is a difference between a first amplitude A1 of the electric field of the incident broadband terahertz radiation beam 926 in a first spectral region 938 including the terahertz resonance frequency and a second amplitude A2 of the electric field of the incident broadband terahertz radiation beam 926 in a second spectral region 940 spaced from the first spectral region 938.

In this embodiment, the controller 932 can be configured to determine a ratio of the first amplitude A1 and the second amplitude A2, which can be mapped to conductivity values based on some calibration data.

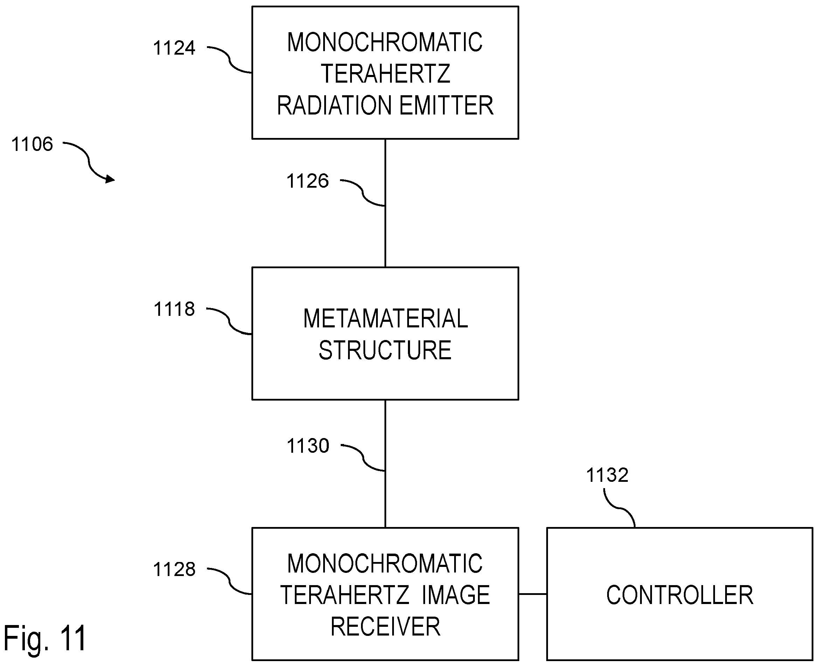

Fig. 11 shows another example of an electronic device testing system 1106, in accordance with another embodiment. As depicted, the electronic device testing system 1106 has a single monochromatic terahertz radiation emitter 1124 which is configured to emit a monochromatic terahertz radiation beam 1126 towards the metamaterial structure 1118.

The monochromatic terahertz radiation beam 1126 is said to be monochromatic as it can have power at the terahertz resonance frequency of the metamaterial structure. As can be understood, in this case, the terahertz frequency of the monochromatic terahertz radiation beam 1126 must be set to the terahertz resonance frequency of the metamaterial structure. It can have power at other frequencies, however it is not necessary in this example.

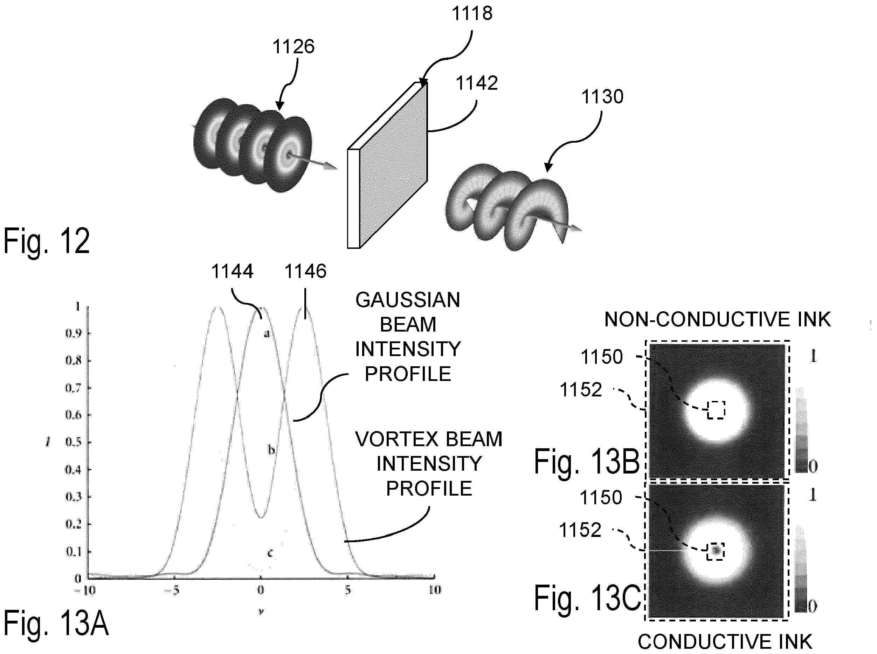

In this example, the metamaterial structure 1118 is provided in the form of a vortex phase plate 1142. As best seen in Fig. 12, and with reference to Fig. 13A, the vortex phase plate 1142 is configured to modify a first spatial distribution 1144 of the incident monochromatic terahertz radiation beam 1126 into a second, different spatial distribution 1146 of the outgoing terahertz radiation beam 1130. In this specific example, the first spatial distribution 1144 is a Gaussian spatial intensity distribution. Hence, the vortex phase plate 1142 modifies the Gaussian spatial distribution into a vortex spatial intensity distribution, which has less power in a center thereof. As can be understood, in such situations, the outgoing terahertz radiation beam 1130 has a doughnut shape, a corkscrew-shaped wavefront and/or an orbital angular momentum. However, it will be understood that the spatial distribution of the incident terahertz radiation beam can vary from one embodiment to another. For instance, the first spatial distribution 1144 can be a top hat power distribution in some embodiments.

Referring back to Fig. 11, the electronic device testing system 1106 also has a single monochromatic terahertz image receiver 1128 which is configured to receive a terahertz radiation beam 1130 outgoing from the metamaterial structure 1118 and to provide an image of the outgoing terahertz radiation beam 1130.

In this example, the controller 1132 receives data indicative of the image of the outgoing terahertz radiation beam 1130 as measured by the monochromatic terahertz image receiver 1128.

As can be understood, in this example, when the ink is not satisfactorily conductive, the first spatial distribution 1144 of the incident monochromatic terahertz radiation beam 1126 remains unchanged or almost unchanged, as shown in the image of Fig. 13B. However, when the ink is satisfactorily conductive, the second spatial distribution 1146 of the incident monochromatic terahertz radiation beam 1126 can change into the second spatial distribution, lacking power in a center region 1150 of the outgoing terahertz radiation beam 1130 compared to power in a region 1152 surrounding the center region 1150, such as shown in the image of Fig. 13C.

In some embodiments, the conductivity value can depend on a ratio between a first integrated amplitude bounded in the center region 1150 of the image and a second integrated amplitude of a region including the center 1150 and the surrounding region 1152.

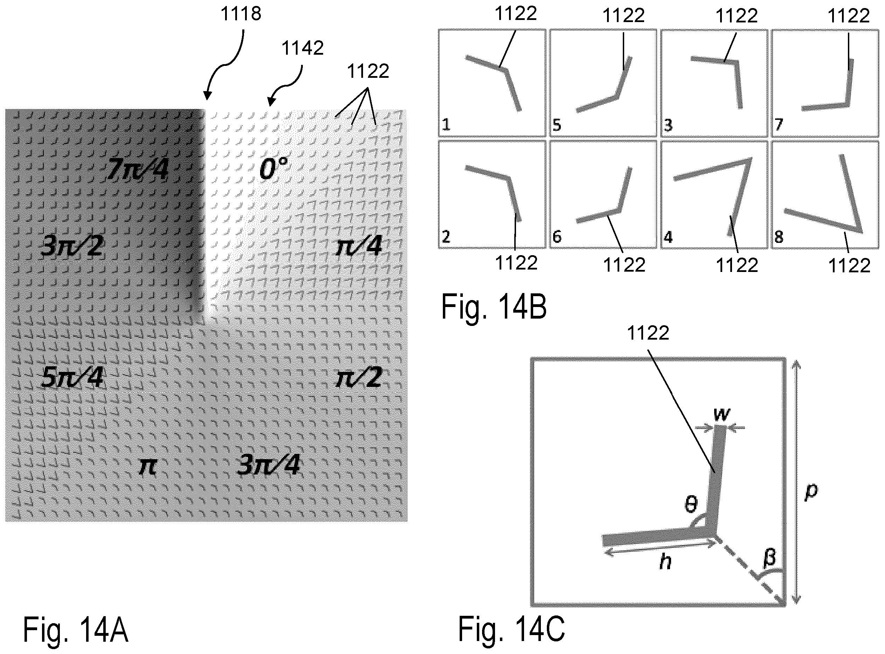

Fig. 14A shows an example of the vortex phase plate 1142, in accordance with one or more embodiments. As shown, the vortex phase plate 1142 includes a plurality of subsets of V-shaped or elbow-shaped elements 1122 where the elbow-shaped elements 1122 associated to each subset have a corresponding elbow angle $\theta$, such as shown in Figs. 14B and 14C.

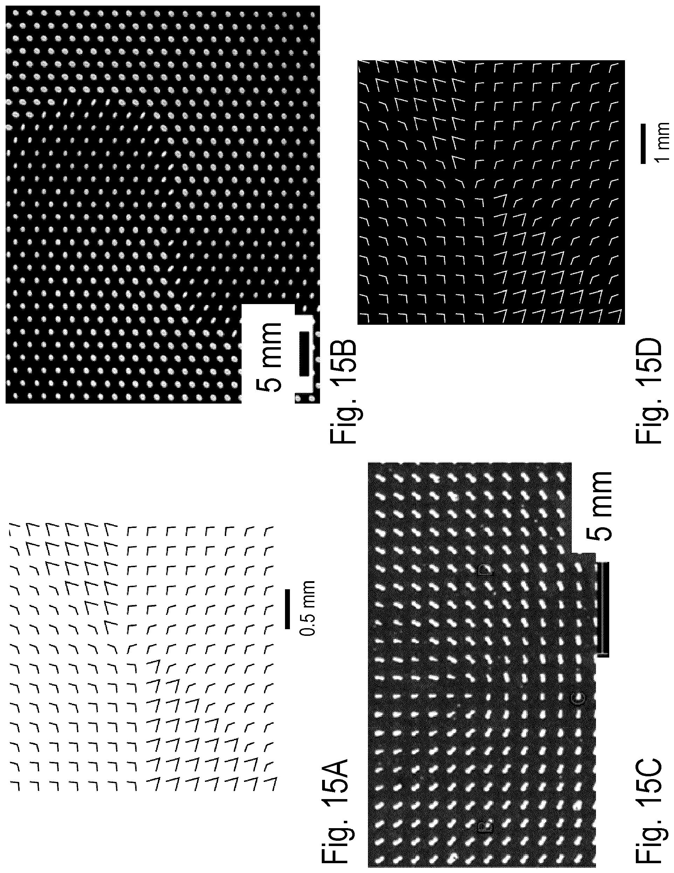

Figs. 15A-D show examples of such vortex phase plates, in accordance with some other embodiments. In the examples of Figs. 15A, 15B and 15C, the elements are positively printed on the substrate. However, in some other embodiments, such as in the example of Fig. 15D, the elements are negatively printed, i.e., a stencil is printed using the ink where the stencil has a plurality of spaced-apart apertures left untouched therein. It is noted that the vortex phase plate shown in Fig. 15B is inspired from A. Arbabi, et al. Nature Nanotechnology volume 10, pages 937-943 (2015) whereas the vortex phase plate shown in Fig. 15C is inspired from H.-T. Chen, A. J. Taylor, and N. Yu, A review of metasurfaces: physics and applications, Rep. Prog. Phys. 79, 076401 (2016).

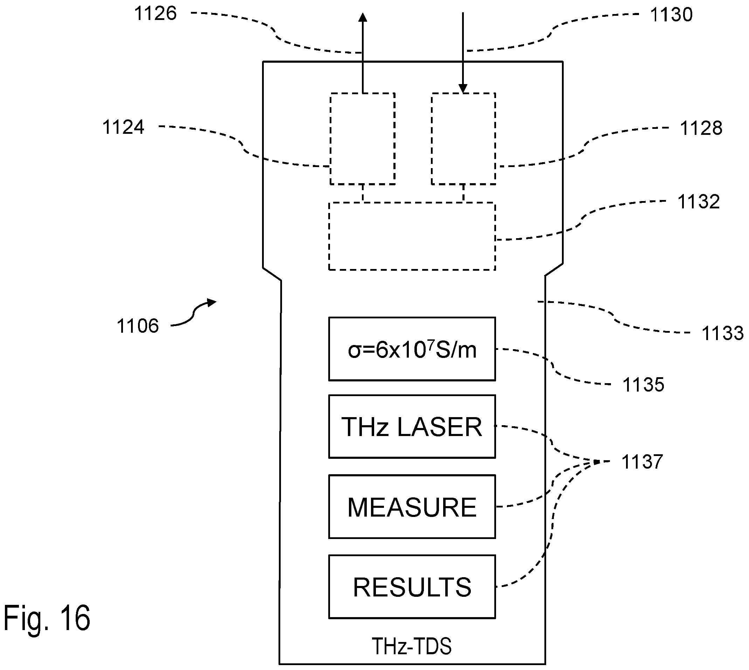

As can be understood, the electronic device testing system 1106 can be enclosed within a portable frame 1133, such as the one shown in Fig. 16. Indeed, in this embodiment, the monochromatic terahertz radiation emitter and image receiver 1124 and 1128 are provided in the form of complementary metal-oxide-semiconductor (CMOS) devices which can have a reduced footprint compared to broadband terahertz radiation emitters and receivers. The electronic device testing system 1106 also has a display 1135 which can display any conductivity values by the controller 1132. Buttons 1137 can be provided also to initiate measurements and/or display measurement results on the display 1135. Example of such CMOS devices can be described in the following references: R. A. Hadi, et al., IEEE Journal of Solid-State Circuits 47, 2999 (2012); X. Wu et al., IEEE J. of Solid-State Circuits 51, 3049 (2016); M. M. Assefzadeh and A. Babakhani, IEEE J. Solid State Circuits 52, 2905 (2017); X. Wu and K. Sengupta, IEEE J. Solid State Circuits 52, 389 (2017); K. Sengupta and A. Hajimiri, IEEE J. Solid State Circuits 47, 3013 (2012); and J. Grzyb, B. Heinemann, and U. R. Pfeiffer, IEEE Trans. Microwave Theory Tech. 65, 4357 (2017).

Example 1 - Contactless *In Situ* Electrical Characterization Method of Printed Electronic Devices with Terahertz Spectroscopy

Printed electronic devices are attracting significant interest due to their versatility and low cost; however, quality control during manufacturing can be a significant challenge, at it may prevent the widespread adoption of such promising technology. In this example, it is shown that terahertz (THz) radiation can be used for the *in situ* inspection of printed electronic devices, as confirmed through a comparison with conventional electrical conductivity methods. This *in situ* method consists of printing a simple test pattern exhibiting a distinct signature in the THz range, i.e., a metamaterial such as described above, that enables the precise characterization of the static electrical conductivities of the printed ink. It is demonstrated that contactless dual-wavelength THz spectroscopy analysis, which can require only a single THz measurement, can be more precise and repeatable than conventional four-point probe conductivity measurements. The following results can open the door to a simple strategy for performing contactless quality control in real time of printed electronic devices at any stage of its production line.

Indeed, printable electronics (PE) manufacturing technology can be interesting to a large range of industries, from consumer goods, electronics, aerospace, automotive, pharmaceutical, biomedical, to textiles and fashion. It can offer an attractive alternative to conventional circuit manufacturing by enabling lower-cost, maskless, and rapid production of customized electronic devices. PE is compatible with a wide range of substrates, as long as they are not porous and can resist all fabrication steps, including pre- and post-printing processes. In addition, various kinds of conductive, semi-conductive, and dielectric inks are now commercially available. Therefore, PE allows the realization of unique electronic components that can be bent, twisted and stretched, all while retaining their electrical properties. In recent years, the development of various contact- and non-contact printing technologies, such as flexography, gravure, screen- or inkjet-printing, has advanced significantly. Post-printing processes also play a key role in the manufacturing of PE devices. The most commonly used sintering approaches are conventional thermal annealing, electrical sintering, microwave, and photonic sintering by either continuous-wave laser irradiation or high-power flashing lamps. While the spatial resolution and definition of the device are related to the printing method, the quality of the electrical properties of the printed devices is directly related to the post-printing process. Particularly, the solid and uniform dielectric or metallic tracks from the printed pattern are obtained during this step.

The quality of PE devices can be evaluated using different types of microscopy, such as atomic force microscopy, scanning electron microscopy or optical microscopy, which are well-established tools for analyzing the surface morphology of materials. Nevertheless, these techniques can be expensive, slow, and allow limited surface area observation. Other types of characterization techniques, such as crystallography analysis, thermography, elecro- or photo-luminescence, may also be time-consuming and can require special conditions, such as vacuum or helium environments, to avoid noise and damage. The electrical conductivity of printed traces in flexible PE circuits can be assessed using conventional methods drawn from the electronics industry, e.g., the flying probes or four-point probe method (4PP). However, these techniques cannot be envisioned for high-volume roll-to-roll (R2R) printing since in-line contact methods are not compatible with continuous manufacturing tools. Thus, the non-contact conductivity characterization method described herein can be practical in at least some situations.

Traditional graphic art printing or off-set printing used in the manufacture of full-color magazines, posters, packaging, etc., evaluates print quality using a color control bar (GATF Standard Offset Color Bar). Using a densitometer or a spectrophotometer, these bars allow for accurate determination of ink density, dot gain, and screen angle accuracy. Generally, the color control bars are printed away from the immediate image area, and are often cut off or hidden during final assembly. Similarly, for PE production, an *in situ* quality control characterization technique has to be developed. Time-domain spectroscopy (TDS), using electromagnetic terahertz (THz) radiation, i.e., for frequencies ranging from about 100 GHz to about 10 THz, is a powerful tool that allows non-destructive characterization, and which is very sensitive to the conductivity of matter. THz waves have previously been used to characterize carbon printed ink with the THz imaging method. However, for high volume production, such approach is time consuming and may require complicated data analysis to efficiently recover the conductive property of the printed devices. Alternatively, THz engineered structures, such as metamaterials, can exhibit a strong response in transmission- or reflection-type geometries with a high dependency on material conductivity. Therefore, it can provide a straightforward sensing tool to retrieve the conductive property of the printed ink. Already, THz metamaterials printed by inkjet, digital aerosol jet, laser printing or electrohydrodynamic jet printing have been reported, allowing for rapid fabrication of THz metamaterial-based sensors and functional THz devices using PE methods.

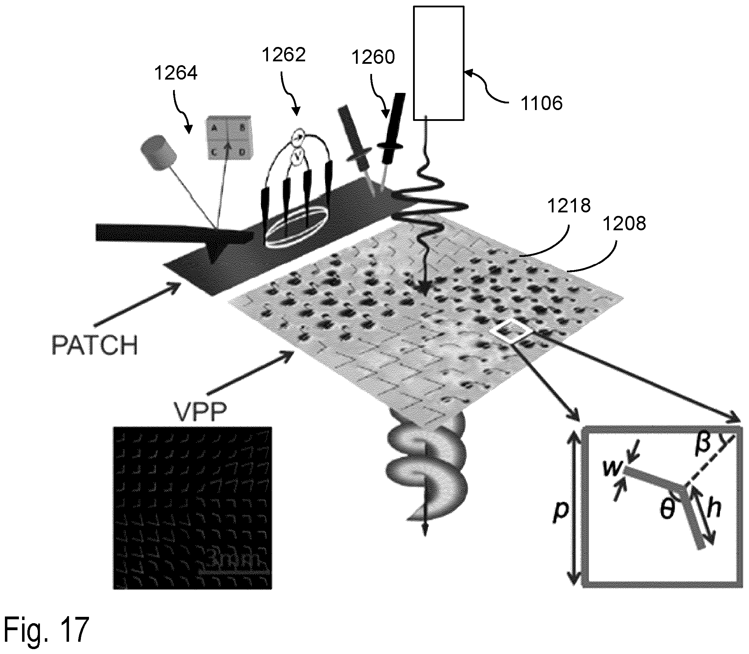

In this example, a THz engineered resonance structure (also referred to as "metamaterial structure" in this disclosure) has been developed as a quality control bar to probe the post-printing manufacturing process of PE devices. Some objectives were to determine the transmission resonant behavior of a control bar using THz waves as a function of ink conductivity and to link the THz frequency conductivity with the static conductivity of printed devices that are manufactured simultaneously (i.e., with the same sintering condition). As illustrated in Fig. 17, a comparative study was performed between THz inspection of a resonant metamaterial structure 1218 printed on a substrate 1208 using the electronic device testing system 1106 and conventional conductivity measurement methods, i.e., using a multimeter (MM) measurement setup 1260, a four-point probe (4PP) measurement setup 1262 and an atomic force microscopy (AFM) measurement setup 1264. The THz measurements performed using the electronic device testing system 1106 are well-correlated with the non-resonant printed structure conductivities and confirm the ability to determine the quality of the post-printing manufacturing process of PE devices by THz inspection of a simple control bar showing a distinctive response in the THz frequency range. To retrieve the resonance response of the control bar, standard terahertz time-domain spectroscopy (THz-TDS) was utilized. In addition, the well-known THz transmission method was compared through a novel dual-wavelength THz spectroscopy (DWTS) analysis. It is showed herein that DWTS determines the conductivity of the PE device using a single scan measurement. Additionally, the proposed method may not rely on THz phase-sensitive measurements, and is therefore ideally suited for next-generation low-cost THz emitters and sensors and opens the door to contactless *in situ* quality control of PE devices.

A special printed pattern sample was designed consisting of two parts: (i) a resonant structure at THz frequency, and (ii) a rectangular "patch" sample. These two patterns will serve as comparative tools between THz spectroscopy and conventional methods described herein, respectively. As shown in Fig. 17, the resonant "control bar" consists of a THz vortex phase plate (VPP) made of V-shape antennas, whereas the "patch" consists of a $1 \times 10$ mm$^2$ printed rectangular shape.

The unit cell design of the VPP antenna yields a specific resonant response to electromagnetic waves, and as commonly known for metamaterial structures, these properties are preserved in a macroscopic medium fabricated from their individual units. Similarly, as for electrically tunable metamaterials, here the variability in resonance response was probed as a function of ink conductivity. As expected for metamaterials, a printed VPP sample with lower conductivity will cause the resonance to be damped.

The VPP with topological number I = 1 was designed according to the work of Jignwen He et al.. It is made of eight sectors in this example, which supply a phase changing from 0 to $2\pi$ with a step size of $\pi/4$. Each sector was formed from one type of V-shaped antenna, as depicted in the right inset of Fig. 17, and made from two rectangular slits attached at one end at a specific angle ($\theta$), in which geometrical parameters include dimensions of p = 600 $\mu$m, w = 30 $\mu$m, $\beta$ = 45 for all antennas. The length of the slit h = 234, 246, 270, 450 $\mu$m and the angle between slits $\theta$ = 130°, 120°, 100°, 60° according to order of antennas in the literature. Similarly, all geometrical aspect values of angles $\theta$ and $\beta$ were kept, whereas $\beta$ was the angle between the bisector line of a V-shaped antenna and the x-axis. Due to the resolution of the printer, and according to the frequency spectrum of the terahertz radiation source, the dimensions of the unit cell (p) and the length of the slit (h) were increased threefold. A feature width (w) of 30 $\mu$m was set and chosen according to the minimum dimension of printed silver ink traces, only limited by the printer spatial resolution. The right inset of Fig. 17 illustrates one of the eight types of antennas with the notation of geometrical parameters. The full sample area consisted of 30 $\times$ 30 V-shaped antennas, with its central frequency expected to be around 0.25 THz.

All samples were printed using a Ceradrop F-Serie Inkjet Printer (Limoges, France) with 1 pl Dimatix cartridge (FUJIFILM Dimatix, Santa Clara, CA, USA) that dispensed drops with a droplet spacing (center-to-center distance between ejected drops) of 20 $\mu$m. Only one nozzle was used to perform the printing. The jetting frequency was set at 500 Hz. A commercially available conductive silver ink DGP 40TE-20C (ANP, Pleasanton, CA, USA) was used that contains silver nanoparticles (Ag NPs) of sizes around 50 nm with 30-35 wt.% in triethylene glycol monomethyl ether solvent. The substrate used for printing was a heat-stabilized polyethylene terephthalate (PET) polyester film (Melinex ST505, New Berlin, WI, USA). The chuck was maintained at a constant temperature of 60 ° C during the printing process. An *in situ* Adphos Near Infrared (NIR) Dryer Module CER-42-250 (Bruckmühl, Germany) was used to perform the annealing step of the printed patterns. The displacement time of the lamp was varied from 0.03 s/mm to 0.2 s/mm in order to obtain a set of samples with different thermal histories, resulting in a range of conductivities. A confocal laser microscope (Olympus LEXT OLS4000, Center Valley, PA, USA) was used to determine the thickness of the printed structure, which was found to be around 400 nm. The left inset of Fig. 17 shows a visible image of the center part of a printed vortex phase plate. The precise definition of the V-shaped antennas observed in the left inset of Fig. 17 confirms the ability of the inkjet printer to achieve the proper design.

Assessments of the VPP control pattern were performed using (THz Time-Domain Spectroscopy) THz-TDS measurements. An ultrafast Ti:Sapphire oscillator laser with a center wavelength of 805 nm producing pulses with a duration of ~20 fs and a repetition rate of 80 MHz was used in combination with two LT-GaAs photoconductive antennas from Teravil (Vilnius, Lithuania). A beam splitter 80:20 splits the laser beam into an optical pump and a probe beam for THz generation and detection, respectively. The emitter and the detector were placed in front of each other, separated by a distance of around 40 cm. An optical chopper at 330 Hz was placed just after the emitter, allowing for lock-in detection. The samples were placed between the emitter and detector at normal incidence for transmission spectroscopy in air at room temperature and pressure.

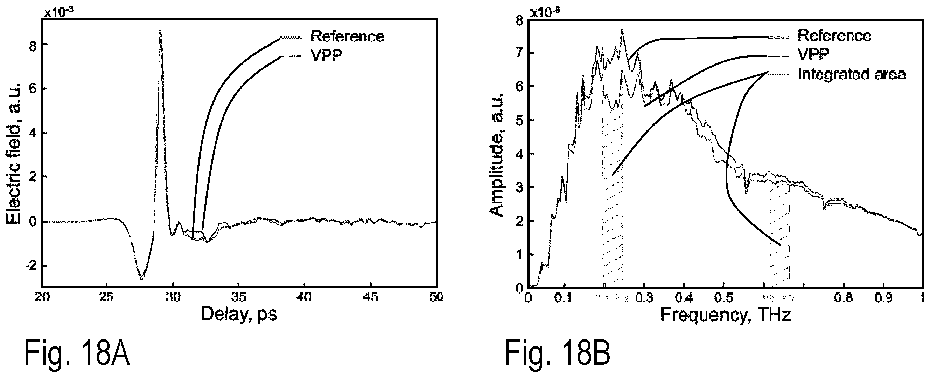

To obtain the THz transmission value of the VPP sample, two THz pulses were acquired in the time domain, i.e., the reference ($E_{ref}(t)$) and the sample ($E_{sam}(t)$) signals, as shown in Fig. 18A. An unpatterned PET substrate served as a reference. The normalized transmission $T(\omega)$ was obtained in the frequency domain using the following relation:

$$T(\omega) = \left| \frac{E_{ref}(\omega)}{E_{sam}(\omega)} \right|. \tag{1}$$

The vortex beam retained its shape after propagating through a homogeneous medium or at the focus of a lens. This point is crucial in order to still be able to retrieve the transmission dip at vortex frequency using a single pixel detector (i.e., at the focus of a photoconductive THz detector).

The analysis of THz-TDS data via normalized amplitude in the frequency domain required two THz measurements: reference and signal, respectively. Unfortunately, these measurements are sensitive to environmental conditions, which could induce some unwanted variations between each subsequent measurement. For spectroscopic methods in the visible and ultraviolet range, such unwanted fluctuations are often avoided by a dual wavelength measurement approach. The principle is simple: simultaneously measuring at two wavelengths (reference and signal) and recording the difference values at these wavelengths, also called balanced measurement. This method has been used in the medical field to extract the concentration of drugs in tablets using UV radiation. The idea of such methods is to find an intensity dependence ratio between the active element (signal) and the matrix (reference). After a proper calibration, this value is directly proportional to the concentration of an element of interest.

Conventional photoconductive THz antennas emit THz radiation that covers a broad range of frequencies, e.g., typically from 100 GHz to 10 THz. Therefore, differentiating between two distinct signal frequencies, within the same pulse spectrum, is a straightforward manipulation. As shown in Fig. 18B, the process involves the extraction of a signal defined by a specific and narrowband range of frequencies, i.e., from $\omega_1$ to $\omega_2$, which exhibits a distinctive response proportional to the desired parameter (e.g., conductivity). A second frequency range, from $\omega_3$ to $\omega_4$, where no sign of absorption from the sample is detected, is used as reference information. The ratio between these two zones provides information about a transmission level corresponding to the parameter behavior under investigation. Since both signals are taken simultaneously, the noise from the ambient condition is suppressed in the normalization process:

$$I = \frac{\int_{\omega 1}^{\omega 2} |E_{sam}(\omega)| d\omega}{\int_{\omega 3}^{\omega 4} |E_{sam}(\omega)| d\omega'}, \tag{2}$$

where I is the value of ratio and $|E_{sam}(\omega)|$ is the amplitude signal of the measured THz spectrum.

To validate the viability of characterizing printed electronics by electromagnetic THz waves, two conventional conductivity measurement techniques were used: a multimeter with two probes and the state-of-the-art four-point probe methods. In addition, AFM measurements were performed in the surface morphology. Using a conventional multimeter instrument (MM) and two microprobes (S-shaped tungsten micro-probe tips), the electrical conductivity of a print pattern can be extracted using the following equation:

$$\sigma = \frac{L}{RA_c}, \tag{3}$$

where $\sigma$ is the electrical conductivity, R is measured resistance, L and $A_c$ are the length and the cross-section area of a tested printed structure, respectively.

For higher precision, the four-point probe method (4PP) enables precise measurements of the electrical conductivity for a tiny sample within the area of the 4PP arrangement. To ensure a perfect match between our sample size and the 4PP tips, the spacing between probes was set to 100 $\mu$m (MCW-28-7188, GGB industries, Naples, FL, USA ). The measurement with 4PP provides a sheet resistance in which the conductivity value is extracted using the following equation:

$$\sigma = \frac{\ln 2}{\pi t R'}, \tag{4}$$

where the geometric factor $\ln 2/\pi$ describes the current rings emanating from the outer probe tips, t is the thickness of the patch and R is the measured sheet resistance.

To confirm the good agreement between the conductivity of the printed control bar and the conductivity value of the patch, the resistance of a V-shaped antenna with two microprobes (2MP) was measured and its conductivity has been determined using Equation (3). Finally, to ensure that the sintering speed was responsible for the changes in conductivity, the surface morphologies of the printed samples were characterized using the AFM (EnviroScope, Santa Barbara, CA, USA) system in tapping mode.

Five VPP samples with different conductivities were characterized by the THz-TDS described above. The conductivity of each sample was controlled by varying the sintering time. One of the samples (non-sintered) was not sintered by the lamp, but was slightly sintered during the printing step, since the chuck was held at a constant temperature of 60° C. Fig. 3A illustrates the normalized transmission amplitude of the different VPP samples, which were obtained from Equation (1). A dip in the transmission is observed due to the generation of a vortex beam at 0.22 THz, as expected. As mentioned previously, a higher resonance response (i.e., which translates to a lower transmission at 0.22 THz) indicates a sample with higher electrical conductivity.

To validate the accuracy of THz sensing of vortex plates as a function of material conductivity, finite difference time domain (FDTD) simulations were performed using the Lumerical software. Linearly polarized waves and perfectly matched layer boundary conditions were used in the simulation.

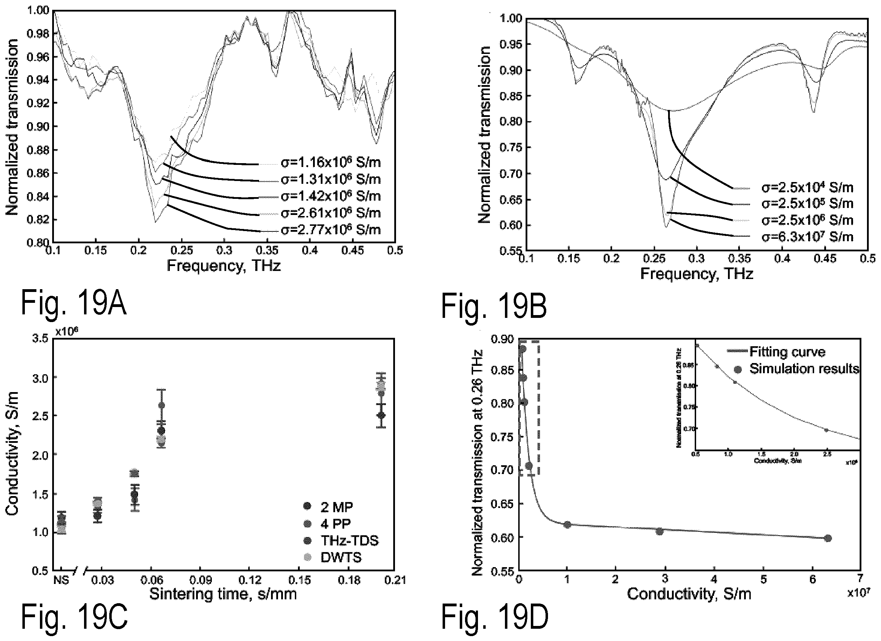

Fig. 19B shows the simulated transmission spectra of VPPs with defined and uniform conductivities of a hypothetical printed metal. We placed VPP in the air in order to avoid Fabry-Perot resonances from the substrate. We can observe three transmission dips; the strongest one at 0.265 THz represents the central frequency of VPP. Compared to experiments, the red shift of the central frequency is explained by the absence of the PET substrate.

The simulation and experiment differ in the degree of transmission difference as a function of metal conductivity.

This difference can be attributed to the perfect reading of the central vortex information in the simulated case. Essentially, the photoconductive antenna reads a spatially integrated range of information containing the central intensity part of a donut shaped beam, together with a large contribution from its wings. Nevertheless, the numerical simulations are in good agreement with experimental findings.

Fig. 19C gives the measured conductivity of five samples using three different methods: 2MP, 4PP, THz-TDS and DWTS as a function of sintering speed. The 4PP method was performed on the patch samples, while 2MP, THz-TDS and DWTS measurements provide the corresponding conductivity results from the VPP samples. The function of the value of the dip in transmission against the conductivity of VPP was also simulated, as shown in Fig. 19D. It is important to note that this function clearly reveals the extremely high sensitivity of THz wave sensing for low conductivity samples (e.g., below $1 \times 10^7$ S/m, the blue dotted region in inset). Above this conductivity value, the dip in transmission exhibits less sensitivity, with an almost saturated behavior (i.e., closer to a perfect metal resonance).

To compare the performance of THz-TDS and 4PP, the THz transmission amplitudes at 0.22 THz were calibrated to the expected conductivity values obtained from 4PP. Since the 4PP measurements cover a limited range of conductivity, from $1 \times 10^6$ to $3 \times 10^6$ S/m, a simple calibration using a linear fit was chosen (in agreement with inset of Fig. 19D, with the non-sintered sample as the starting point. In Fig. 19C, the similar increases in conductivity behavior as a function of sintering exposure time for the measurements taken by THz-TDS and 4PP is observed. More importantly, all sintering conditions are well discriminated by THz measurements, whereas 4PP failed in differentiating the three lowest conductivity conditions (i.e., $<1.5 \times 10^6$ S/m), as well as the two highest conductivity conditions (i.e., $>2.5 \times 10^6$ S/m). In addition, we repeated the measurements ten times for each method and calculated the standard deviation. Interestingly, THz-TDS exhibits better repeatability than the conventional 4PP method. This difference can be attributed to the contactless nature of the THz method: 4PP can locally damage the ink surface and may render repeated measurement less accurate.

In the second step, using the data obtained from THz-TDS measurements, the sample signal was analyzed using the DWTS method. The two frequency ranges were 0.195-0.244 THz and 0.615-0.664 THz, for the signal and reference, respectively (see Fig. 18B). In order to perform the measurement in ambient conditions, the reference frequency range was chosen to avoid the water absorption lines that can occur due to ambient humidity. Similarly to THz-TDS transmission data, the integral values from DWTS were normalized and calibrated with respect to the retrieved conductivity using the 4PP method. The behavior follows the expected static conductivity, but more importantly, the repeatability is four times better than the conventional 4PP method.

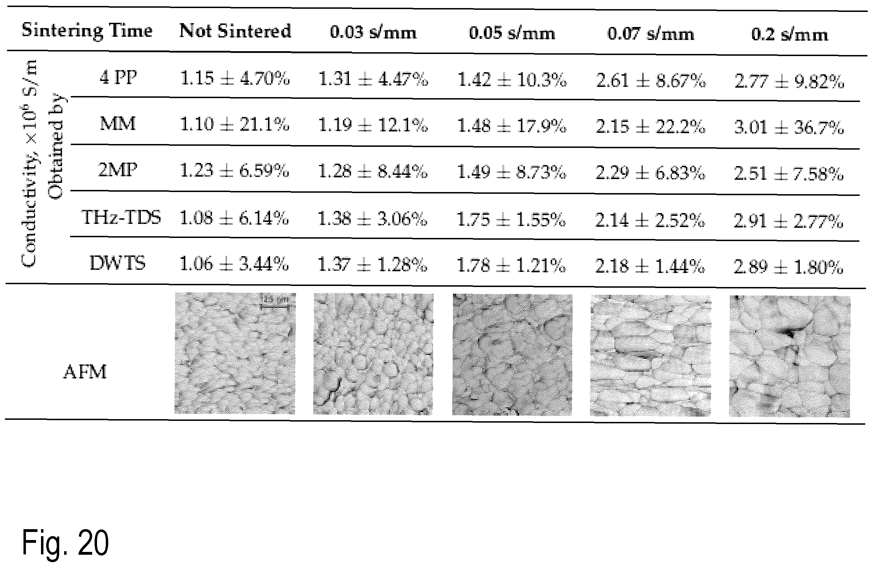

In a final step, the analysis done was reviewed on the patch versus VPP samples using the various methods described previously. The table presented in Fig. 20 summarizes the obtained results. In this table, 4PP denotes four-point probe measurements, MM denotes multimeter measurements, 2MP denotes two microprobes measurements, THz-TDS denotes terahertz time-domain spectroscopy measurements, DWTS denotes dual-wavelength terahertz spectroscopy measurements and AFM denotes atomic force microscopy measurements. The scale of atomic force microscopy (AFM) images is the same for all figures shown in this example.

In order to establish a comparative measurement performance, several resistance measurements were carried out at different locations for the patch and V-shaped antenna and present their relative standard deviation (RSD). As mentioned previously, the 4PP and multimeter retrieved the resistance on the patch. To clearly validate that VPP conductivity is linked to the patch conductivities, 2MP were also used to evaluate the VPP resistance directly. It has to be mentioned that, due to the extremely small effective volume of VPP unit cell, the 2MP method can easily over- or underestimate the conductivity (e.g., conductivity dependency on sample volume, as shown in Equation (3)). However, the 2MP measurements confirmed the good agreement between the sintering exposure time for the patch and VPP samples together. In order to confirm the provided conductivity measurements, the evolution of the sintering of Ag ink was studied using AFM analysis at five different sintering stages. The last row of this table depicts the printed ink surfaces after sintering. The non-NIR-sintered sample (NS) showed poor contact between Ag NPs, resulting in the lowest conductivity ($1.15 \times 10^6$ S/m). The sample with the shortest annealing time (0.03 s/mm) depicted the next stage of the sintering, necks began to grow between NPs prompted by surface energy minimization. With a longer annealing time of 0.05 s/mm, the NPs get more compact and the printed structure densifies. The slight increase of annealing time to 0.07 s/mm led to a further increase in conductivity. The longest annealing time (0.2 s/mm) led to the highest density and the highest conductivity ($2.77 \times 10^6$ S/m). According to AFM observations of the surface morphology of the samples, the obtained samples were consistent with the sintering parameters and measurements of the conductivity with different techniques.

As can also be seen in the table of Fig. 20, as expected, the measurements provided by a conventional multimeter were the least precise since the probes of the multimeter easily break the surface of the patch after contact. Meanwhile, the micro-probe provides a safer way to avoid destroying the sample surface. The average conductivities measured with the different techniques are in the same range, and have similar behavior as a function of the sintering time. It should be emphasized that the trend in electrical static conductivity measurements on the printed patch and the VPP using the different techniques are all in good agreement. This confirms the feasibility of characterizing the variability in ink conductivity during mass production of PE devices simply by reading a test structure. Finally, the best RSD for repeatability was obtained for DWTS andTHz-TDS.

In conclusion, a quality control bar was developed for industrial production of PE devices based on a VPP working in the THz range. The VPP was formed from V-shaped antennas with a central frequency at 0.220 THz. The samples were printed with commercially available ink consisting of silver nanoparticles, and a commercial inkjet printer was used for the fabrication. The conductivities of the printed samples were varied by changing the speed of a near-infrared heater. THz-TDS was employed to analyze the transmission properties of printed VPP. The results showed that the THz transmission response of a resonant sample enables to follow the changes in sintering condition of the printed ink. The results were validated with a simulation study and introduced DWTS as a simple and fast method to quickly determine the transmission response of VPP. This example also confirms the similar conductivity behavior between adjacent printed structures and VPP sample as function of sintering exposure time. This important observation enables to track the changes in sintering process of PE devices during the manufacturing process using a simple control bar.

Finally, using the conventional four-point-probe method as a reference, it is confirmed that a calibrated quality control bar in the shape of the VPP, or any other resonant metamaterial structure printed on the substrate using the ink to qualify, could be used to determine the static electrical properties of non-resonant printed devices that are printed simultaneously with the VPP samples. Being a non-contact method, it is highly suitable for in-line characterization of high-speed roll-to-roll printing repeatability of PE devices.

As can be understood, the examples described above and illustrated are intended to be exemplary only. For instance, the printed electronic device can by any suitable type of electronic device including, but not limited to, flexible displays, curved smartphones, blood glucose tests, antennas, freshness sensors, solar cells, e-boards and the like. Moreover, the printing techniques can include, but not limited to, screen printing, flexography printing, gravure printing, offset lithography printing, inkjet printing, digital aerosol jet printing, laser printing, electrohydrodynamic jet printing, sintering (e.g., thermal sintering, laser sintering, UV sintering) and the like. The scope is indicated by the appended claims.

**Claims**

1. An electronic device testing system (106) for testing an electronic device (104) having a substrate (108) on which is printed a metamaterial structure (118, 118a, 118b) using an ink (112), the metamaterial structure (118, 118a, 118b) comprising a pattern (121) of elements (122) providing a terahertz resonance frequency to the metamaterial structure (118, 118a, 118b) using the ink (112), the electronic device testing system (106) comprising:

   a terahertz radiation emitter (124) configured to emit an incident terahertz radiation beam (126, 1126) to be incident on the metamaterial structure (118, 118a, 118b) of the substrate (108), the incident terahertz radiation beam (126, 1126) having power at least the terahertz resonance frequency of the metamaterial structure (118, 118a, 118b);
   a terahertz radiation receiver (128) configured to receive an outgoing terahertz radiation beam (130, 1130) outgoing from the metamaterial structure (118, 118a, 118b); and
   a controller (132, 732) communicatively coupled to at least the terahertz radiation receiver (128);
   **characterized in that**:

   the terahertz radiation receiver (128) is configured to measure an amplitude of an electric field of the outgoing terahertz radiation beam (130, 1130) at least at the terahertz resonance frequency; and
   the controller (132) is configured to determine a conductivity value indicative of a conductivity of the ink (112) based on said amplitude and to generate a signal indicative of an action to be performed when the determined conductivity of the ink (112) is below a given conductivity threshold.

2. The electronic device testing system (106) of claim 1, wherein the terahertz radiation emitter (124) is a broadband terahertz radiation emitter (724), the terahertz radiation receiver (128) being configured to measure a spectral power distribution of the outgoing terahertz radiation beam (130), the system (106) further comprising a broadband terahertz radiation reference receiver (736) configured to measure a spectral power distribution of a portion of the incident terahertz radiation beam (126, 1126), the controller (132, 732) being configured to determine the conductivity value based on the spectral power distribution of the incident terahertz radiation beam (126, 1126) and on the spectral power distribution of the outgoing terahertz radiation beam (130, 1130).

3. The electronic device testing system (106) of claim 1 wherein the terahertz radiation emitter (124) is a broadband terahertz radiation emitter (724), the terahertz radiation receiver (128) being configured to measure a spectral power distribution of the outgoing terahertz radiation beam (130, 1130), the controller (132, 732) being configured to determine the conductivity value based on an amplitude of a first spectral region (938) including the terahertz resonance frequency and on an amplitude of a second spectral region (940) being spectrally spaced-apart from the first spectral region (938).

4. The electronic device testing system (106) of any one of claims 1 to 3 wherein the metamaterial structure (118, 118a, 118b) is provided in the form of a vortex phase plate (1142).

5. The electronic device testing system (106) of claim 4 wherein the terahertz radiation receiver (128) is a terahertz radiation image receiver (1128), the controller (132, 732) being configured to determine the conductivity value based on an amplitude of the electric field of the outgoing terahertz radiation beam (1130) at a central region thereof.

6. The electronic device testing system (106) of claim 5 wherein the terahertz radiation emitter (124) and the terahertz radiation receiver (128) are complementary metal-oxide-semiconductor devices, the electronic device testing system (106) being portable.

7. A method for testing an electronic device (104) having an electronic circuit (110) being printed on a given area (116) of a substrate (108) using an ink (112) and a metamaterial structure (118, 118a, 118b) being printed on a remaining area of the substrate (108), the metamaterial structure (118, 118a, 118b) comprising a pattern of elements providing a terahertz resonance frequency to the metamaterial structure (118, 118a, 118b) using the ink (112), the method comprising:

emitting an incident terahertz radiation beam (126, 1126) on the metamaterial structure (118, 118a, 118b) of the substrate (108), the incident terahertz radiation beam (126, 1126) having power at least at the terahertz resonance frequency of the metamaterial structure (118, 118a, 118b), thereby causing an outgoing terahertz radiation beam (130, 1130) to be outgoing from the metamaterial structure (118, 118a, 118b);
the metamaterial structure (118, 118a, 118b) modifying a first spectral power distribution of the incident terahertz radiation beam (126, 1126) and thereby causing the outgoing terahertz radiation beam (130, 1130) to have a second spectral power distribution being different from the first spectral power distribution;
**characterized in that** the method comprises:

measuring an amplitude of an electric field of the outgoing terahertz radiation beam (130, 1130) at least at the terahertz resonance frequency; and
using a controller (132, 732) being communicatively coupled to at least the terahertz radiation receiver (128), determining a conductivity value indicative of a conductivity of the ink (112) based on said amplitude.

8. The method of claim 7, wherein the incident terahertz radiation beam (126, 1126) is a broadband terahertz radiation beam (726), said measuring including measuring a spectral power distribution of the outgoing terahertz radiation beam (130, 1130), the method further comprising measuring a spectral power distribution of a portion of the incident terahertz radiation beam (126, 1126), said determining including determining the conductivity value based on the spectral power distribution of the incident terahertz radiation beam (126, 1126) and on the spectral power distribution of the outgoing terahertz radiation beam (130, 1130).

9. The method of claim 7 wherein the incident terahertz radiation beam (126, 1126) is a broadband terahertz radiation beam (726), said measuring including measuring a spectral power distribution of the outgoing terahertz radiation beam (130, 1130), said determining comprising determining the conductivity value based on an amplitude of a first spectral region (938) including the terahertz resonance frequency and on an amplitude of a second spectral region (940) being spectrally spaced-apart from the first spectral region (938).

10. The method of any one of claims 7 to 9 wherein the metamaterial structure (118, 118a, 118b) is provided in the form of a vortex phase plate (1142), said measuring including measuring an image of the outgoing terahertz radiation beam (130, 1130), said determining comprising determining the conductivity value based on an amplitude of the electric field of the outgoing terahertz radiation beam (130, 1130) at a central region thereof.

11. The method of any one of claims 7 to 10 further comprising, upon determining that the conductivity value is lower than a conductivity value threshold, generating a signal indicative of an action to be performed.

12. The method of claim 11 wherein said action including generating a file indicating that the electronic device has been printed with unsatisfactory ink.

13. The method of any one of claims 7 to 12 further comprising, upon determining that the conductivity value is lower than a conductivity value threshold, updating current printing parameters to updated printing parameters based on said determined conductivity value.

14. The method of claim 13 further comprising reprinting the electronic circuit (110) on the given area (116) of the substrate (108) based on said updated printing parameters.

15. The method of any one of claims 7 to 14 further comprising printing the metamaterial structure (118, 118a, 118b) on the remaining area of the substrate (108) using the ink (112).


**Patentansprüche**

1. Elektronisches Vorrichtungstestsystem (106) zum Testen einer elektronischen Vorrichtung (104) mit einem Substrat (108), auf das eine Metamaterialstruktur (118, 118a, 118b) unter Verwendung einer Tinte (112) gedruckt ist, wobei die Metamaterialstruktur (118, 118a, 118b) ein Muster (121) von Elementen (122) umfasst, die eine Terahertz-Resonanzfrequenz für die Metamaterialstruktur (118, 118a, 118b) unter Verwendung der Tinte (112) bereitstellen, das elektronische Vorrichtungstestsystem (106) umfassend:

   Einen Terahertz-Strahlungsemitter (124), der so konfiguriert ist, dass er einen einfallenden Terahertz-Strahl (126, 1126) emittiert, der auf die Metamaterialstruktur (118, 118a, 118b) des Substrats (108) auftrifft, wobei der einfallende Terahertz-Strahl (126, 1126) mindestens die Terahertz-Resonanzfrequenz der Metamaterialstruktur (118, 118a, 118b) aufweist,
   einen Terahertz-Strahlungsempfänger (128), der so konfiguriert ist, dass er einen von der Metamaterialstruktur (118, 118a, 118b) ausgehenden Terahertz-Strahl (130, 1130) empfängt; und
   einen Controller (132, 732), der mindestens mit dem Terahertz-Strahlungsempfänger (128) kommunikativ verbunden ist,
   **dadurch gekennzeichnet, dass**:

   Der Terahertz-Strahlungsempfänger (128) so konfiguriert ist, dass er eine Amplitude eines elektrischen Feldes des ausgehenden Terahertz-Strahls (130, 1130) mindestens bei der Terahertz-Resonanzfrequenz misst, und
   der Controller (132) so konfiguriert ist, dass er einen Leitfähigkeitswert bestimmt, der eine Leitfähigkeit der Tinte (112) auf der Grundlage der Amplitude anzeigt, und ein Signal erstellt, das eine auszuführende Aktion anzeigt, wenn die bestimmte Leitfähigkeit der Tinte (112) unter einem gegebenen Leitfähigkeitsschwellenwert liegt.

2. Elektronisches Vorrichtungstestsystem (106) nach Anspruch 1, wobei der Terahertz-Strahlungsemitter (124) ein Breitband-Terahertz-Strahlungsemitter (724) ist und der Terahertz-Strahlungsempfänger (128) so konfiguriert ist, dass er eine spektrale Leistungsverteilung des ausgehenden Terahertz-Strahls (130) misst, das System (106), ferner umfassend einen Breitband-Terahertz-Strahlungsreferenzempfänger (736), der so konfiguriert ist, dass er eine spektrale Leistungsverteilung eines Abschnitts des einfallenden Terahertz-Strahls (126, 1126) misst, wobei der Controller (132, 732) so konfiguriert ist, dass er den Leitfähigkeitswert auf der Grundlage der spektralen Leistungsverteilung des einfallenden Terahertz-Strahls (126, 1126) und der spektralen Leistungsverteilung des ausgehenden Terahertz-Strahls (130, 1130) bestimmt.

3. Elektronisches Vorrichtungstestsystem (106) nach Anspruch 1, wobei der Terahertz-Strahlungsemitter (124) ein Breitband-Terahertz-Strahlungsemitter (724) ist und der Terahertz-Strahlungsempfänger (128) so konfiguriert ist, dass er eine spektrale Leistungsverteilung des ausgehenden Terahertz-Strahls (130, 1130) misst, der Controller (132, 732) so konfiguriert ist, dass er den Leitfähigkeitswert auf der Grundlage einer Amplitude eines ersten Spektralbereichs (938), der die Terahertz-Resonanzfrequenz einschließt, und einer Amplitude eines zweiten Spektralbereichs (940), der spektral von dem ersten Spektralbereich (938) beabstandet ist, bestimmt.

4. Elektronisches Vorrichtungstestsystem (106) nach einem der Ansprüche 1 bis 3, wobei die metamaterielle Struktur (118, 118a, 118b) in Form einer Wirbelphasenplatte (1142) bereitgestellt wird.

5. Elektronisches Vorrichtungstestsystem (106) nach Anspruch 4, wobei der Terahertz-Strahlungsempfänger (128) ein Terahertz-Strahlungsbildempfänger (1128) ist und der Controller (132, 732) so konfiguriert ist, dass er den Leitfähigkeitswert basierend auf einer Amplitude des elektrischen Feldes des ausgehenden Terahertz-Strahls (1130) in einem zentralen Bereich davon bestimmt.

6. Elektronisches Vorrichtungstestsystem (106) nach Anspruch 5, wobei der Terahertz-Strahlungsemitter (124) und der Terahertz-Strahlungsempfänger (128) komplementäre Metall-Oxid-Halbleiter-Vorrichtungen sind und das elektronische Vorrichtungstestsystem (106) tragbar ist.

7. Verfahren zum Testen einer elektronischen Vorrichtung (104) mit einer elektronischen Schaltung (110), die unter Verwendung einer Tinte (112) auf einen gegebenen Bereich (116) eines Substrats (108) gedruckt wird, und einer Metamaterialstruktur (118, 118a, 118b), die auf einen verbleibenden Bereich des Substrats (108) gedruckt wird, wobei die Metamaterialstruktur (118, 118a, 118b) ein Muster von Elementen umfasst, die der Metamaterialstruktur (118, 118a, 118b) unter Verwendung der Tinte (112) eine Terahertz-Resonanzfrequenz verleihen, das Verfahren umfassend:

Emittieren eines einfallenden Terahertz-Strahls (126, 1126) auf die metamaterielle Struktur (118, 118a, 118b) des Substrats (108), wobei der einfallende Terahertz-Strahl (126, 1126) eine Leistung mindestens bei der Terahertz-Resonanzfrequenz der metamateriellen Struktur (118, 118a, 118b) hat, wodurch ein ausgehender Terahertz-Strahl (130, 1130) von der metamateriellen Struktur (118, 118a, 118b) ausgeht;
wobei die Metamaterialstruktur (118, 118a, 118b) eine erste spektrale Leistungsverteilung des einfallenden Terahertz-Strahls (126, 1126) modifiziert und dadurch bewirkt, dass der ausgehende Terahertz-Strahls (130, 1130) eine zweite spektrale Leistungsverteilung aufweist, die sich von der ersten spektralen Leistungsverteilung unterscheidet;
**dadurch gekennzeichnet, dass** das Verfahren Folgendes umfasst:

Messen einer Amplitude eines elektrischen Feldes des ausgehenden Terahertz-Strahls (130, 1130) mindestens bei der Terahertz-Resonanzfrequenz; und
Verwenden eines Controllers (132, 732), der kommunikativ mit mindestens dem Terahertz-Strahlungsempfänger (128) gekoppelt ist, Bestimmen eines Leitfähigkeitswertes, der eine Leitfähigkeit der Tinte (112) anzeigt, basierend auf der Amplitude.

8. Verfahren nach Anspruch 7, wobei es sich bei dem einfallenden Terahertz-Strahl (126, 1126) um einen breitbandigen Terahertz-Strahl (726) handelt, wobei das Messen das Messen einer spektralen Leistungsverteilung des ausgehenden Terahertz-Strahls (130, 1130) einschließt, wobei das Verfahren ferner das Messen einer spektralen Leistungsverteilung eines Abschnitts des einfallenden Terahertz-Strahls (126, 1126), wobei das Bestimmen das Bestimmen des Leitfähigkeitswertes auf der Grundlage der spektralen Leistungsverteilung des einfallenden Terahertz-Strahls (126, 1126) und der spektralen Leistungsverteilung des ausgehenden Terahertz-Strahls (130, 1130) einschließt.

9. Verfahren nach Anspruch 7, wobei es sich bei dem einfallenden Terahertz-Strahl (126, 1126) um einen breitbandigen Terahertz-Strahl (726) handelt, wobei das Messen das Messen einer spektralen Leistungsverteilung des ausgehenden Terahertz-Strahls (130, 1130) einschließt, wobei das Bestimmen das Bestimmen des Leitfähigkeitswertes auf der Grundlage einer Amplitude eines ersten Spektralbereichs (938), der die Terahertz-Resonanzfrequenz einschließt, und auf der Grundlage einer Amplitude eines zweiten Spektralbereichs (940), der spektral von dem ersten Spektralbereich (938) beabstandet ist, einschließt.

10. Verfahren nach einem der Ansprüche 7 bis 9, wobei die Metamaterialstruktur (118, 118a, 118b) in Form einer Wirbelphasenplatte (1142) vorgesehen ist, wobei das Messen das Messen eines Bildes des ausgehenden Terahertz-Strahls (130, 1130) einschließt, wobei das Bestimmen das Bestimmen des Leitfähigkeitswertes basierend auf einer Amplitude des elektrischen Feldes des ausgehenden Terahertz-Strahls (130, 1130) in einem zentralen Bereich davon einschließt.

11. Verfahren nach einem der Ansprüche 7 bis 10, ferner umfassend das Erzeugen eines Signals, das eine auszuführende Aktion anzeigt, wenn festgestellt wird, dass der Leitfähigkeitswert niedriger als ein Leitfähigkeitsschwellenwert ist.

12. Verfahren nach Anspruch 11, wobei die Aktion das Erzeugen einer Datei einschließt, die anzeigt, dass die elektronische Vorrichtung mit unzureichender Tinte bedruckt wurde.

**13.** Verfahren nach einem der Ansprüche 7 bis 12, ferner umfassend, wenn festgestellt wird, dass der Leitfähigkeitswert niedriger als ein Leitfähigkeitsschwellenwert ist, das Aktualisieren der aktuellen Druckparameter zu aktualisierten Druckparametern basierend auf dem festgestellten Leitfähigkeitswert.

**14.** Verfahren nach Anspruch 13, ferner umfassend das Neudrucken der elektronischen Schaltung (110) auf der gegebenen Fläche (116) des Substrats (108) auf der Grundlage der aktualisierten Druckparameter.

**15.** Verfahren nach einem der Ansprüche 7 bis 14, ferner umfassend das Drucken der Metamaterialstruktur (118, 118a, 118b) auf die verbleibende Fläche des Substrats (108) unter Verwendung der Tinte (112).

**Revendications**

**1.** Système de test de dispositif électronique (106) pour tester un dispositif électronique (104) comportant un substrat (108) sur lequel est imprimée une structure de métamatériau (118, 118a, 118b) en utilisant une encre (112), la structure de métamatériau (118, 118a, 118b) comprenant un motif (121) d'éléments (122) fournissant une fréquence de résonance en térahertz à la structure de métamatériau (118, 118a, 118b) en utilisant l'encre (112), le système de test de dispositif électronique (106) comprenant :

un émetteur de rayonnement en térahertz (124) configuré pour émettre un faisceau de rayonnement en térahertz incident (126, 1126) pour qu'il soit incident sur la structure de métamatériau (118, 118a, 118b) du substrat (108), le faisceau de rayonnement en térahertz incident (126, 1126) ayant une puissance au moins à la fréquence de résonance en térahertz de la structure de métamatériau (118, 118a, 118b) ;
un récepteur de rayonnement en térahertz (128) configuré pour recevoir un faisceau de rayonnement en térahertz sortant (130, 1130) sortant de la structure de métamatériau (118, 118a, 118b) ; et
un dispositif de commande (132, 732) couplé en communication au moins au récepteur de rayonnement en térahertz (128) ;
**caractérisé en ce que** :

le récepteur de rayonnement en térahertz (128) est configuré pour mesurer une amplitude d'un champ électrique du faisceau de rayonnement en térahertz sortant (130, 1130) au moins à la fréquence de résonance en térahertz ; et
le dispositif de commande (132) est configuré pour déterminer une valeur de conductivité indicative d'une conductivité de l'encre (112) sur la base de ladite amplitude et pour générer un signal indicatif d'une action à réaliser lorsque la conductivité déterminée de l'encre (112) est inférieure à un seuil de conductivité donné.

**2.** Système de test de dispositif électronique (106) selon la revendication 1, dans lequel l'émetteur de rayonnement en térahertz (124) est un émetteur de rayonnement en térahertz à bande large (724), le récepteur de rayonnement en térahertz (128) étant configuré pour mesurer une distribution de puissance spectrale du faisceau de rayonnement en térahertz sortant (130), le système (106) comprenant en outre un récepteur de référence de rayonnement en térahertz à bande large (736) configuré pour mesurer une distribution de puissance spectrale d'une partie du faisceau de rayonnement en térahertz incident (126, 1126), le dispositif de commande (132, 732) étant configuré pour déterminer la valeur de conductivité sur la base de la distribution de puissance spectrale du faisceau de rayonnement en térahertz incident (126, 1126) et de la distribution de puissance spectrale du faisceau de rayonnement en térahertz sortant (130, 1130).

**3.** Système de test de dispositif électronique (106) selon la revendication 1, dans lequel l'émetteur de rayonnement en térahertz (124) est un émetteur de rayonnement en térahertz à bande large (724), le récepteur de rayonnement en térahertz (128) étant configuré pour mesurer une distribution de puissance spectrale du faisceau de rayonnement en térahertz sortant (130, 1130), le dispositif de commande (132, 732) étant configuré pour déterminer la valeur de conductivité sur la base d'une amplitude d'une première région spectrale (938) incluant la fréquence de résonance en térahertz et d'une amplitude d'une seconde région spectrale (940) étant espacée spectralement de la première région spectrale (938).

**4.** Système de test de dispositif électronique (106) selon l'une quelconque des revendications 1 à 3, dans lequel la structure de métamatériau (118, 118a, 118b) est prévue sous la forme d'une plaque de phase tourbillonnaire (1142).

**5.** Système de test de dispositif électronique (106) selon la revendication 4, dans lequel le récepteur de rayonnement en térahertz (128) est un récepteur d'image de rayonnement en térahertz (1128), le dispositif de commande (132, 732) étant configuré pour déterminer la valeur de conductivité sur la base d'une amplitude du champ électrique du faisceau de rayonnement en térahertz sortant (1130) au niveau d'une région centrale de celui-ci.

6. Système de test de dispositif électronique (106) selon la revendication 5, dans lequel l'émetteur de rayonnement en térahertz (124) et le récepteur de rayonnement en térahertz (128) sont des dispositifs métal-oxyde-semi-conducteur complémentaires, le système de test de dispositif électronique (106) étant portable.

7. Procédé pour tester un dispositif électronique (104) comportant un circuit électronique (110) étant imprimé sur une zone donnée (116) d'un substrat (108) en utilisant une encre (112) et une structure de métamatériau (118, 118a, 118b) étant imprimée sur une zone restante du substrat (108), la structure de métamatériau (118, 118a, 118b) comprenant un motif d'éléments fournissant une fréquence de résonance en térahertz à la structure de métamatériau (118, 118a, 118b) en utilisant l'encre (112), le procédé comprenant :

   l'émission d'un faisceau de rayonnement en térahertz incident (126, 1126) sur la structure de métamatériau (118, 118a, 118b) du substrat (108), le faisceau de rayonnement en térahertz incident (126, 1126) ayant une puissance au moins à la fréquence de résonance en térahertz de la structure de métamatériau (118, 118a, 118b), en amenant de ce fait un faisceau de rayonnement en térahertz sortant (130, 1130) à être sortant de la structure de métamatériau (118, 118a, 118b) ;
   la modification, par la structure de métamatériau (118, 118a, 118b), d'une première distribution de puissance spectrale du faisceau de rayonnement en térahertz incident (126, 1126) en amenant de ce fait le faisceau de rayonnement en térahertz sortant (130, 1130) à avoir une seconde distribution de puissance spectrale différente de la première distribution de puissance spectrale ;
   **caractérisé en ce que** le procédé comprend :

   la mesure d'une amplitude d'un champ électrique du faisceau de rayonnement en térahertz sortant (130, 1130) au moins à la fréquence de résonance en térahertz ; et
   en utilisant un dispositif de commande (132, 732) couplé en communication au moins au récepteur de rayonnement en térahertz (128), la détermination d'une valeur de conductivité indicative d'une conductivité de l'encre (112) sur la base de ladite amplitude.

8. Procédé selon la revendication 7, dans lequel le faisceau de rayonnement en térahertz incident (126, 1126) est un faisceau de rayonnement en térahertz à bande large (726), ladite mesure incluant la mesure d'une distribution de puissance spectrale du faisceau de rayonnement en térahertz sortant (130, 1130), le procédé comprenant en outre la mesure d'une distribution de puissance spectrale d'une partie du faisceau de rayonnement en térahertz incident (126, 1126), ladite détermination incluant la détermination de la valeur de conductivité sur la base de la distribution de puissance spectrale du faisceau de rayonnement en térahertz incident (126, 1126) et de la distribution de puissance spectrale du faisceau de rayonnement en térahertz sortant (130, 1130).

9. Procédé selon la revendication 7, dans lequel le faisceau de rayonnement en térahertz incident (126, 1126) est un faisceau de rayonnement en térahertz à bande large (726), ladite mesure incluant la mesure d'une distribution de puissance spectrale du faisceau de rayonnement en térahertz sortant (130, 1130), ladite détermination comprenant la détermination de la valeur de conductivité sur la base d'une amplitude d'une première région spectrale (938) incluant la fréquence de résonance en térahertz et d'une amplitude d'une seconde région spectrale (940) étant espacée spectralement de la première région spectrale (938).

10. Procédé selon l'une quelconque des revendications 7 à 9, dans lequel la structure de métamatériau (118, 118a, 118b) est prévue sous la forme d'une plaque de phase tourbillonnaire (1142), ladite mesure incluant la mesure d'une image du faisceau de rayonnement en térahertz sortant (130, 1130), ladite détermination comprenant la détermination de la valeur de conductivité sur la base d'une amplitude du champ électrique du faisceau de rayonnement en térahertz sortant (1130) au niveau d'une région centrale de celui-ci.

11. Procédé selon l'une quelconque des revendications 7 à 10, comprenant en outre, à la détermination que la valeur de conductivité est inférieure à un seuil de valeur de conductivité, la génération d'un signal indicatif d'une action à réaliser.

12. Procédé selon la revendication 11, dans lequel ladite action inclut la génération d'un fichier indiquant que le dispositif électronique a été imprimé avec une encre insatisfaisante.

**13.** Procédé selon l'une quelconque des revendications 7 à 12, comprenant en outre, à la détermination que la valeur de conductivité est inférieure à un seuil de valeur de conductivité, la mise à jour de paramètres d'impression courants à des paramètres d'impression mis à jour sur la base de ladite valeur de conductivité déterminée.

**14.** Procédé selon la revendication 13, comprenant en outre la réimpression du circuit électronique (110) sur la zone donnée (116) du substrat (108) sur la base desdits paramètres d'impression mis à jour.

**15.** Procédé selon l'une quelconque des revendications 7 à 14, comprenant en outre l'impression de la structure de métamatériau (118, 118a, 118b) sur la zone restante du substrat (108) en utilisant l'encre (112).

Fig. 1

EP 3 803 355 B1

104

116

108

110

120

121

118

122

112

Fig. 2

Fig. 3B

Fig. 3A

400

| |
|---|
| Print a metamaterial structure on a remaining area of the substrate using the ink, the metamaterial structure comprising a pattern of elements providing a terahertz resonance frequency to the metamaterial structure |

402

| |
|---|
| Emit a terahertz radiation emitter incident on the metamaterial structure of the substrate, the incident terahertz radiation beam having power at at least the terahertz resonance frequency of the metamaterial structure |

404

| |
|---|
| Measure an amplitude of an electric field of the outgoing terahertz radiation beam at at least the terahertz resonance frequency |

406

| |
|---|
| Determine a conductivity value indicative of a conductivity of the ink based on the measured amplitude |

408

| |
|---|
| Generate a signal indicative of an action to be performed when the determined conductivity of the ink is below a given conductivity threshold |

410

Fig. 4

EP 3 803 355 B1

Fig. 5

EP 3 803 355 B1

DATA

↓

| SOFTWARE APPLICATION |
| --- |

600 ⌇

DATABASE(S) ⌇ 602

↓

CONDUCTIVITY VALUE

Fig. 6

Fig. 7

TERAHERTZ RESONANCE FREQUENCY

Fig. 8A

Fig. 8B

906

924 — BROADBAND
TERAHERTZ
RADIATION EMITTER

926

918 — METAMATERIAL
STRUCTURE

930

932

928 — BROADBAND
TERAHERTZ
RADIATON RECEIVER

CONTROLLER

Fig. 9

Fig. 10

EP 3 803 355 B1

1124 — MONOCHROMATIC
TERAHERTZ
RADIATION EMITTER

1106

1126 —

1118 — METAMATERIAL
STRUCTURE

1130 —

1132

1128 — MONOCHROMATIC
TERAHERTZ IMAGE
RECEIVER

CONTROLLER

Fig. 11

**Fig. 12**

GAUSSIAN BEAM INTENSITY PROFILE

VORTEX BEAM INTENSITY PROFILE

**Fig. 13A**

NON-CONDUCTIVE INK

**Fig. 13B**

CONDUCTIVE INK

**Fig. 13C**

Fig. 14B

Fig. 14C

Fig. 14A

Fig. 15B

Fig. 15D

Fig. 15A

Fig. 15C

Fig. 16

σ=6x10⁷S/m

THz LASER

MEASURE

RESULTS

THz-TDS

1126

1130

1124

1128

1132

1133

1135

1137

1106

EP 3 803 355 B1

36

Fig. 17

Fig. 18B

Fig. 18A

Fig. 19A

Fig. 19B

Fig. 19C

Fig. 19D

| Sintering Time | Not Sintered | 0.03 s/mm | 0.05 s/mm | 0.07 s/mm | 0.2 s/mm |
|---|---|---|---|---|---|
| 4 PP | $1.15 \pm 4.70\%$ | $1.31 \pm 4.47\%$ | $1.42 \pm 10.3\%$ | $2.61 \pm 8.67\%$ | $2.77 \pm 9.82\%$ |
| MM | $1.10 \pm 21.1\%$ | $1.19 \pm 12.1\%$ | $1.48 \pm 17.9\%$ | $2.15 \pm 22.2\%$ | $3.01 \pm 36.7\%$ |
| 2MP | $1.23 \pm 6.59\%$ | $1.28 \pm 8.44\%$ | $1.49 \pm 8.73\%$ | $2.29 \pm 6.83\%$ | $2.51 \pm 7.58\%$ |
| THz-TDS | $1.08 \pm 6.14\%$ | $1.38 \pm 3.06\%$ | $1.75 \pm 1.55\%$ | $2.14 \pm 2.52\%$ | $2.91 \pm 2.77\%$ |
| DWTS | $1.06 \pm 3.44\%$ | $1.37 \pm 1.28\%$ | $1.78 \pm 1.21\%$ | $2.18 \pm 1.44\%$ | $2.89 \pm 1.80\%$ |
| AFM | | | | | |

Conductivity, $\times 10^6$ S/m Obtained by

Fig. 20

EP 3 803 355 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZENG YANG et al.** Terahertz characterisation of UV offset lithographically printed electronic-ink. *Organic Electronics,* 10 June 2017, vol. 48, 382-388
- **A. ARBABI et al.** *Nature Nanotechnology,* 2015, vol. 10, 937-943
- **H.-T. CHEN ; A. J. TAYLOR ; N. YU.** A review of metasurfaces: physics and applications. *Rep. Prog. Phys,* 2016, vol. 79, 076401
- **R. A. HADI et al.** *IEEE Journal of Solid-State Circuits,* 2012, vol. 47, 2999
- **X. WU et al.** *IEEE J. of Solid-State Circuits,* 2016, vol. 51, 3049
- **M. M. ASSEFZADEH ; A. BABAKHANI.** *IEEE J. Solid State Circuits,* 2017, vol. 52, 2905
- **X. WU ; K. SENGUPTA.** *IEEE J. Solid State Circuits,* 2017, vol. 52, 389
- **K. SENGUPTA ; A. HAJIMIRI.** *IEEE J. Solid State Circuits,* 2012, vol. 47, 3013
- **J. GRZYB ; B. HEINEMANN ; U. R. PFEIFFER.** *IEEE Trans. Microwave Theory Tech,* 2017, vol. 65, 4357